# EUROPÄISCHE PATENTANMELDUNG

(11) **EP 3 961 306 A2**
(43) Veröffentlichungstag der Anmeldung: **02.03.2022**
(21) Anmeldenummer: 21174908.0
(22) Anmeldetag: 20.05.2021
(51) Int. Cl.: G03F 7/20, G02B 7/00, G02B 7/182

(54) **KOMPENSATION VON KRIECHEFFEKTEN IN EINER ABBILDUNGSEINRICHTUNG**

(30) Priorität: 29.06.2020 DE 102020208012
(71) Anmelder: Carl Zeiss SMT GmbH, 73447 Oberkochen (DE)
(72) Erfinder: Bektas Knauf, Eylem, 73432 Aalen (DE); Schönhoff, Ulrich, 89073 Ulm (DE); Nefzi, Marwene, 89073 Ulm (DE); Zweering, Ralf, 73431 Aalen (DE)
(74) Vertreter: Carl Zeiss SMT GmbH

(57) **Zusammenfassung**

Die vorliegende Erfindung betrifft eine Anordnung einer optischen Abbildungseinrichtung für die Mikrolithographie, insbesondere für die Verwendung von Licht im extremen UV-Bereich (EUV), mit einer ersten Stützstruktur (111.1) und einer zweiten Stützstruktur (111.2), wobei die erste Stützstruktur (111.1) dazu ausgebildet ist, wenigstens ein optisches Element (107.2) der Abbildungseinrichtung abzustützen. Die erste Stützstruktur (111.1) stützt die zweite Stützstruktur (111.2) über eine Mehrzahl von Stützfedereinrichtungen (113.1) einer Schwingungsentkopplungseinrichtung (113) ab, wobei die Stützfedereinrichtungen (113.1) kinematisch parallel zueinander zwischen der ersten Stützstruktur (111.1) und der zweiten Stützstruktur (111.2) wirken. Jede der Stützfedereinrichtungen (113.1) definiert eine Stützkraftrichtung sowie eine Stützlänge entlang der Stützkraftrichtung. Die zweite Stützstruktur (111.2) stützt eine Messeinrichtung (109.1) ab, die zum Messen der Position und/oder Orientierung des wenigstens einen optischen Elements (107.2) bezüglich einer Referenz (112) in wenigstens einem Freiheitsgrad ausgebildet ist. Es ist eine Kriechkompensationseinrichtung (115) zur Kompensation einer Änderung einer statischen Relativlage zwischen der ersten Stützstruktur (111.1) und der zweiten Stützstruktur (111.2) in wenigstens einem Korrekturfreiheitsgrad vorgesehen, die sich aus einem Kriechprozess der Stützfedereinrichtung (113.1) ergibt. Die Kriechkompensationseinrichtung (115) umfasst eine kinematisch parallel zu den Stützfedereinrichtungen (113.1) zwischen der ersten Stützstruktur (111.1) und der zweiten Stützstruktur (111.2) wirkende, ansteuerbare aktive Stelleinrichtung (115.1) mit wenigstens einer aktiven Aktuatoreinheit (115.2). Die Stelleinrichtung (115.1) ist dazu ausgebildet, eine Stellkraft auf die zweite Stützstruktur (111.2) auszuüben und zur zumindest teilweisen Kompensation der Relativlageänderung die Stellkraft zu verändern.

## Beschreibung

Die vorliegende Erfindung betrifft eine optische Anordnung für die Mikrolithographie, die für die Verwendung von UV Nutzlicht geeignet ist, insbesondere von Licht im extremen ultravioletten (EUV) Bereich. Weiterhin betrifft die Erfindung eine optische Abbildungseinrichtung mit einer solchen Anordnung. Die Erfindung lässt sich im Zusammenhang mit beliebigen optischen Abbildungsverfahren einsetzen. Besonders vorteilhaft lässt sie sich bei der Herstellung oder der Inspektion mikroelektronischer Schaltkreise sowie der hierfür verwendeten optischen Komponenten (beispielsweise optischer Masken) einsetzen.

Die im Zusammenhang mit der Herstellung mikroelektronischer Schaltkreise verwendeten optischen Einrichtungen umfassen typischerweise eine Mehrzahl optischer Elementeinheiten, die ein oder mehrere optische Elemente wie Linsen, Spiegel oder optische Gitter umfassen, die im Abbildungslichtpfad angeordnet sind. Diese optischen Elemente wirken typischerweise in einem Abbildungsprozess zusammen, um ein Bild eines Objekts (beispielsweise ein auf einer Maske gebildetes Muster) auf ein Substrat (beispielsweise einen so genannten Wafer) zu transferieren. Die optischen Elemente sind typischerweise in einer oder mehreren funktionalen Gruppen zusammengefasst, die gegebenenfalls in separaten Abbildungseinheiten gehalten sind. Insbesondere bei hauptsächlich refraktiven Systemen, die mit einer Wellenlänge im so genannten Vakuum-Ultraviolett-Bereich (VUV, beispielsweise bei einer Wellenlänge von 193 nm) arbeiten, sind solche Abbildungseinheiten häufig aus einem Stapel optischer Module gebildet, die ein oder mehrere optische Elemente halten. Diese optischen Module umfassen typischerweise eine Stützstruktur mit einer im Wesentlichen ringförmigen äußeren Stützeinheit, die einen oder mehrere optische Elementhalter abstützt, die ihrerseits das optische Element halten.

Die immer weiter voranschreitende Miniaturisierung von Halbleiterbauelementen führt zu einem ständigen Bedarf an erhöhter Auflösung der für ihre Herstellung verwendeten optischen Systeme. Dieser Bedarf an erhöhter Auflösung bedingt den Bedarf an einer erhöhten numerischen Apertur (NA) und einer erhöhten Abbildungsgenauigkeit der optischen Systeme.

Ein Ansatz, um eine erhöhte optische Auflösung zu erhalten, besteht darin, die Wellenlänge des in dem Abbildungsprozess verwendeten Lichtes zu verringern. In den vergangenen Jahren wurde verstärkt die Entwicklung von Systemen vorangetrieben, bei denen Licht im so genannten extremen Ultraviolettbereich (EUV) verwendet wird, typischerweise bei Wellenlängen von 5 nm bis 20 nm, in den meisten Fällen bei einer Wellenlänge von etwa 13 nm. In diesem EUV-Bereich ist es nicht mehr möglich, herkömmliche refraktive optische Systeme zu verwenden. Dies ist dadurch bedingt, dass die für refraktive optische Systeme verwendeten Materialien in diesem EUV-Bereich einen Absorptionsgrad aufweisen, der zu hoch ist um mit der verfügbaren Lichtleistung akzeptable Abbildungsergebnisse zu erzielen. Folglich müssen in diesem EUV-Bereich reflektive optische Systeme für die Abbildung verwendet werden.

Dieser Übergang zu rein reflektiven optischen Systemen mit hoher numerischer Apertur (z. B. NA > 0,4) im EUV-Bereich führt zu erheblichen Herausforderungen im Hinblick auf das Design der Abbildungseinrichtung.

Die oben genannten Faktoren führen zu sehr strengen Anforderungen hinsichtlich der Position und/oder Orientierung der optischen Elemente, die an der Abbildung teilnehmen, relativ zueinander sowie hinsichtlich der Deformation der einzelnen optischen Elemente, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die Komponenten der optischen Abbildungseinrichtung (also beispielsweise die optischen Elemente der Beleuchtungseinrichtung, die Maske, die optischen Elemente der Projektionseinrichtung und das Substrat), die bei der Abbildung zusammenwirken, in einer wohldefinierten Weise abgestützt werden, um eine vorgegebene wohldefinierte räumliche Beziehung zwischen diesen Komponenten einzuhalten und eine minimale unerwünschte Deformation dieser Komponenten zu erzielen, um letztlich eine möglichst hohe Abbildungsqualität zu erreichen.

Eine Herausforderung besteht hierbei häufig darin, eine möglichst präzise Messung der Lage (also der Position und/oder Orientierung) der an der Abbildung beteiligten optischen Komponenten (beispielsweise der optischen Elemente) vorzunehmen und die Lage zumindest einzelner dieser optischen Elemente dann über eine entsprechend angesteuerte Lageregeleinrichtung aktiv mit der für den Abbildungsprozess erforderlichen Präzision (typischerweise im Bereich von 1 nm und darunter) und Regelbandbreite (typischerweise bis zu 200 Hz) einzustellen. Ein wesentlicher Faktor für die Präzision der Messung ist dabei die stabile und präzise Abstützung der Messeinrichtung, die für die Messung verwendet wird. Diese Abstützung sollte dabei nach Möglichkeit sicherstellen, dass die Komponenten der Messeinrichtung eine wohldefinierte Lage (d. h. Position und/oder Orientierung) bezüglich einer definierten Referenz aufweisen, auf die das Messergebnis der Messeinrichtung bezogen wird.

Eine in diesem Zusammenhang häufig verwendete Möglichkeit, ist die Abstützung der Messeinrichtung auf einer separaten Stützstruktur, die häufig auch als Sensor-Rahmen (englisch: "sensor frame") oder Metrologie-Rahmen (englisch: "metrology frame") bezeichnet wird. Ein solcher Sensor-Rahmen wird dabei typischerweise auf einer weiteren (ein- oder mehrteiligen) lasttragenden Struktur (englisch: "force frame") abgestützt, die neben dem Sensor-Rahmen über die Lageregeleinrichtung auch zumindest einen Teil der optischen Komponenten (z. B. zumindest einen Teil der optischen Elemente) der Abbildungseinrichtung abstützt. Hierdurch kann sichergestellt werden, dass der Sensor-Rahmen weit gehend von den Stützlasten für die optischen Komponenten frei gehalten werden kann.

Um den Sensor-Rahmen hierbei möglichst weitgehend frei von inneren Störungen der Abbildungseinrichtung (z. B. durch bewegte Komponenten induzierte Vibrationen) und äußeren Störungen (z. B. unerwünschte Erschütterungen) zu halten, ist der Sensor-Rahmen häufig über eine Schwingungsentkopplungseinrichtung schwingungsisoliert bzw. schwingungsentkoppelt auf der lasttragenden Struktur abgestützt. Dies geschieht typischerweise über eine Mehrzahl von Stützfedereinrichtungen der Schwingungsentkopplungseinrichtung.

Während hiermit (auf kurzen Zeitskalen) eine gute dynamische Schwingungsisolierung des Sensor-Rahmens erreicht werden kann, hat es sich jedoch gezeigt, dass es auf langen Zeitskalen im Bereich der Schwingungsentkopplungseinrichtung, insbesondere im Bereich der Stützfedereinrichtungen, zu so genannten Kriecheffekten bzw. Setzeffekten kommen kann. Hierdurch ändert sich langfristig die Lage des Sensor-Rahmens und damit die Lage der für die Ansteuerung der Lageregeleinrichtung verwendeten Referenz bezüglich der lasttragenden Struktur. Eine solche Lageänderung der Referenz wird im Betrieb typischerweise durch die Lageregeleinrichtung kompensiert, die hierzu allerdings ausreichende Verfahrwege, mithin also eine ausreichende Bewegungsreserve zur Verfügung stellen muss und demgemäß entsprechend aufwändig bzw. teuer gestaltet sein muss.

### KURZE ZUSAMMENFASSUNG DER ERFINDUNG

Der Erfindung liegt daher die Aufgabe zugrunde, eine optische Anordnung für die Mikrolithographie und eine entsprechende optische Abbildungseinrichtung mit einer solchen Anordnung sowie ein entsprechendes Verfahren zur Verfügung zu stellen, welche bzw. welches die zuvor genannten Nachteile nicht oder zumindest in geringerem Maße aufweist und insbesondere auf möglichst einfache und kostengünstige Weise eine optische Abbildung möglichst hoher Abbildungsqualität ermöglicht.

Die Erfindung löst diese Aufgabe mit den Merkmalen der unabhängigen Ansprüche.

Der Erfindung liegt die technische Lehre zugrunde, dass man auf einfache und kostengünstige Weise eine optische Abbildung hoher Abbildungsqualität erzielen kann, wenn kinematisch parallel zu den Stützfedereinrichtungen zwischen der lasttragenden ersten Stützstruktur und der die Messeinrichtung tragenden zweiten Stützstruktur eine ansteuerbare aktive Stelleinrichtung wirkt, deren Stellkraft veränderbar ist, um eine Änderung der statischen Relativlage zwischen der ersten Stützstruktur und zweiten Stützstruktur in wenigstens einem Freiheitsgrad zumindest teilweise zu kompensieren.

Dabei kann vorgesehen sein, dass die Stelleinrichtung ausgehend von einem Ausgangszustand, den die Abbildungseinrichtung bzw. ihre Komponenten nach einer initialen Justage der Abbildungseinrichtung (typischerweise unmittelbar bei erstmaliger Inbetriebnahme der Abbildungseinrichtung) innehaben, unmittelbar und/oder zumindest über längere Zeiträume kontinuierlich aktiv ist. Insbesondere kann für das Auslösen einer Betätigung der Stelleinrichtung eine beliebige Schwelle (der Abweichung von dem Ausgangszustand) vorgegeben werden, sodass die Stelleinrichtung schon entsprechend geringe Abweichungen sofort zumindest teilweise kompensiert. Mithin ist es also möglich, dass die Stelleinrichtung sofort mit Inbetriebnahme aktiv ist und die Stellkraft ausübt, wenn sich Kriech- oder Setzeffekte in der Abstützung der zweiten Stützstruktur erfasst werden bzw. sich spürbar ausgewirkt haben, um diese Effekte zumindest teilweise zu kompensieren. Ebenso kann aber auch vorgesehen sein, dass die Stelleinrichtung zunächst keine Stellkraft ausübt. Die Stelleinrichtung kann also gegebenenfalls erst zu einem späteren Zeitpunkt aktiv werden, beispielsweise nachdem sich Kriech- oder Setzeffekte in der Abstützung der zweiten Stützstruktur spürbar ausgewirkt haben, um diese Effekte zumindest teilweise zu kompensieren.

Der Begriff "statische Relativlageänderung" soll dabei im Sinne der vorliegenden Erfindung so verstanden werden, dass es sich um die Änderung der Relativlage bzw. eine Drift zwischen der ersten Stützstruktur und der zweiten Stützstruktur handelt, die im rein statischen Zustand, d. h. ohne dynamische Anregung der Strukturen vorliegt. Wie nachfolgend noch näher erläutert wird, kann eine solche statische Relativlageänderung bzw. Drift über geeignete Verfahren erfasst werden, welche kurzfristige bzw. dynamische Einflüsse herausfiltern. So kann beispielsweise eine einfache Mittelung der Relativlageinformation über geeignet lange Zeiträume erfolgen.

Bei herkömmlichen Gestaltungen kann es je nach Ausmaß der statischen Relativlageänderung zu einer vergleichsweise starken statischen (bzw. nicht-dynamischen) Auslenkung der Lageregeleinrichtung und damit der optischen Elemente aus ihrer ursprünglichen Ausgangslage kommen, mit der diese Relativlageänderung kompensiert wird, mithin also die optischen Elemente dieser Relativlageänderung folgen. Dies kann so weit führen, dass die Lageregeleinrichtung nicht mehr in der Lage ist, den für die dynamische Lageregelung der optischen Elemente im Betrieb erforderlichen Verfahrweg aufzubringen, da sie insoweit an ihre Grenzen stößt.

Dieser Konflikt kann bei herkömmlichen Gestaltungen nur gelöst werden, indem die Lageregeleinrichtung mit einem entsprechend großen Bewegungsspielraum ausgeführt wird, der es erlaubt, über die Lebensdauer der Abbildungseinrichtung entsprechend zu reagieren. Dies ist allerdings mit vergleichsweise hohen Kosten verbunden, da gerade eine Verfahrbewegung mit entsprechend hoher Dynamik nur mit vergleichsweise hohem Aufwand zu realisieren ist. Der Teil des dynamischen Bewegungsspielraumes der Lageregeleinrichtung, mit dem die optischen Elemente der statischen Relativlageänderung nachgeführt werden, ist damit letztlich unter Kostengesichtspunkten verschwendet.

Mit der vorliegenden Korrektur bzw. Kompensation ist es demgegenüber in einfacher und vorteilhafter Weise möglich, die zweite Stützstruktur und damit die Referenz unmittelbar oder nach einer bestimmten, gegebenenfalls auch längeren Betriebszeit, über die sich Kriech- oder Setzeffekte in der Abstützung der zweiten Stützstruktur spürbar ausgewirkt haben, wieder in ihren Ausgangszustand (oder in dessen Nähe) zurückzusetzen, den sie nach einer initialen Justage der Abbildungseinrichtung (typischerweise unmittelbar bei erstmaliger Inbetriebnahme der Abbildungseinrichtung) innehatte. Dies hat zur Folge, dass dann auch die der Referenz folgende Lageregeleinrichtung bzw. die von der Lageregeleinrichtung getragenen optischen Elemente wieder in ihren Ausgangszustand zurückgeholt werden. Eine Drift in der Lageregeleinrichtung wird somit zumindest im Wesentlichen beseitigt.

Hiermit ist es insbesondere in einfacher und vorteilhafter Weise möglich, den maximal erforderlichen bzw. möglichen Verfahrweg der Lageregeleinrichtung vergleichsweise gering zu halten bzw. auf das Nötigste zu beschränken. Insbesondere ist keine große Bewegungsreserve für die Kompensation langfristiger Kriech- oder Setzeffekte vorzuhalten. Diese Bewegungsreserve kann deutlich kleiner gehalten werden.

Nach einem Aspekt betrifft die Erfindung daher eine Anordnung einer optischen Abbildungseinrichtung für die Mikrolithographie, insbesondere für die Verwendung von Licht im extremen UV-Bereich (EUV), mit einer ersten Stützstruktur und einer zweiten Stützstruktur, wobei die erste Stützstruktur dazu ausgebildet ist, wenigstens ein optisches Element der Abbildungseinrichtung abzustützen. Die erste Stützstruktur stützt die zweite Stützstruktur über eine Mehrzahl von Stützfedereinrichtungen einer Schwingungsentkopplungseinrichtung ab, wobei die Stützfedereinrichtungen kinematisch parallel zueinander zwischen der ersten Stützstruktur und der zweiten Stützstruktur wirken. Jede der Stützfedereinrichtungen definiert eine Stützkraftrichtung, in der sie eine Stützkraft zwischen der ersten Stützstruktur und der zweiten Stützstruktur ausübt, sowie eine Stützlänge entlang der Stützkraftrichtung. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Es ist eine Kriechkompensationseinrichtung zur Kompensation einer Änderung einer statischen Relativlage zwischen der ersten Stützstruktur und der zweiten Stützstruktur in wenigstens einem Korrekturfreiheitsgrad vorgesehen, wobei die Relativlageänderung insbesondere durch eine Längenänderung wenigstens einer der Stützfedereinrichtungen entlang ihrer Stützkraftrichtung bedingt ist, die sich aus einem Kriechprozess der Stützfedereinrichtung ergibt. Die Kriechkompensationseinrichtung umfasst eine kinematisch parallel zu den Stützfedereinrichtungen zwischen der ersten Stützstruktur und der zweiten Stützstruktur wirkende, ansteuerbare aktive Stelleinrichtung mit wenigstens einer aktiven Aktuatoreinheit. Die Stelleinrichtung ist dazu ausgebildet, eine Stellkraft auf die zweite Stützstruktur auszuüben und zur zumindest teilweisen Kompensation der Relativlageänderung die Stellkraft zu verändern.

Die Stelleinrichtung kann grundsätzlich auf beliebige geeignete Weise gestaltet sein, um die Stellkraft zu erzeugen. Bevorzugt ist ihre Steifigkeit natürlich auf die Steifigkeit der Stützfedereinrichtungen abgestimmt, um die gewünschte Entkopplungswirkung der Schwingungsentkopplungseinrichtung in den erforderlichen Entkopplungsfreiheitsgraden zu erzielen. Bevorzugt ist die Stelleinrichtung so gestaltet, dass sie in diesen Entkopplungsfreiheitsgraden, in denen die Schwingungsentkopplungseinrichtung eine Entkopplung bereitstellen soll, einen möglichst geringen Beitrag zur Steifigkeit der Abstützung der zweiten Stützstruktur liefert. Vorzugsweise liefert die Stelleinrichtung in diesen Entkopplungsfreiheitsgraden im Wesentlichen keinen Beitrag zur Steifigkeit der Abstützung der zweiten Stützstruktur. Ebenso kann aber auch vorgesehen sein, dass die aktive Stelleinrichtung derart gestaltet ist, dass sie eine negative Steifigkeit aufweist (mithin also ihr Beitrag zur Abstützung der zweiten Stützstruktur mit zunehmender Auslenkung abnimmt), wie nachfolgend noch näher erläutert wird.

Zur Erzeugung der Stellkraft können grundsätzlich beliebige geeignete Aktuatoreinheiten verwendet werden. Bei bevorzugten Varianten umfasst die Stelleinrichtung wenigstens eine aktive Aktuatoreinheit mit einem Reluktanzaktuator. Diese Reluktanzaktuatoren (die auf dem Effekt der Kraftwirkung zur Minimierung des magnetischen Widerstands - der Reluktanz - in einem Magnetkreis basieren) haben beispielsweise gegenüber Lorentz-Aktuatoren insbesondere den Vorteil, dass sie bei vergleichsweise geringerem Bauraum und bei vergleichsweise geringerer Wärmeentwicklung eine vergleichsweise hohe Stellkraft erzeugen können. Darüber hinaus besitzen einige Reluktanzaktuatoren bei Auslenkung aus ihrer Ruhelage (d.h. der Lage mit minimierter Reluktanz) über einen gewissen Stellbereich eine Steifigkeit, die zumindest im Wesentlichen gleich Null ist. Ebenso können aber auch Reluktanzaktuatoren verwendet werden, welche in der oben beschriebenen Weise eine negative Steifigkeit aufweisen. Zusätzlich oder alternativ kann die Stelleinrichtung auch wenigstens eine aktive Aktuatoreinheit mit einem Lorentz-Aktuator umfassen. Auch diese haben den Vorteil, dass sie über einen gewissen Stellbereich eine Steifigkeit aufweisen, die zumindest im Wesentlichen gleich Null ist.

Das Zusammenspiel zwischen den Stützfedereinrichtungen und der Stelleinrichtung kann grundsätzlich auf beliebige geeignete Weise gestaltet sein, um die gewünschte schwingungsentkoppelte Abstützung der zweiten Stützstruktur zu erzielen. So kann die Stelleinrichtung derart ausgebildet sein, dass die Stellkraft die Stützfedereinrichtungen zumindest teilweise entlastet und die Stellkraft zur zumindest teilweisen Kompensation der Relativlageänderung erhöht wird. Ebenso kann die Stelleinrichtung aber auch derart ausgebildet sein, dass die Stellkraft die Stützfedereinrichtungen vorspannt und die Stellkraft zur zumindest teilweisen Kompensation der Relativlageänderung verringert wird. Dabei kann die jeweilige Stelleinrichtung auch so gestaltet sein, dass sie (nach Art von Agonisten und Antagonisten) gegenläufig wirkende Aktuatoreinheiten umfasst, die dann in Summe eine entsprechende Gesamtstellkraft erzeugen.

Bei bestimmten Varianten ist die Stelleinrichtung zur Entlastung der Stützfedereinrichtungen derart ausgebildet, dass die Stellkraft wenigstens einen Anteil der Gesamtgewichtskraft der zweiten Stützstruktur und der von der zweiten Stützstruktur getragenen Komponenten ausgleicht. Dabei kann es ausreichen, die Stelleinrichtung so auszulegen, dass eine Korrektur der Kriech- bzw. Setzeffekte an den Stützfedereinrichtungen erzielt werden kann. Besonders vorteilhaft ist es, wenn dieser Anteil wenigstens 0,1% bis 30%, vorzugsweise wenigstens 0,5% bis 6%, weiter vorzugsweise wenigstens 1% bis 3%, der Gesamtgewichtskraft beträgt. Bei bestimmten Varianten kann es aber auch günstig sein, wenn zumindest ein Großteil der Gewichtskraft durch die Stellkraft aufgenommen wird, die Stützfedereinrichtungen mithin also von den statischen Lasten erheblich entlastet werden und es aufgrund dieser Entlastung auch zu verringerten Kriech- bzw. Setzeffekten kommt.

Die wenigstens eine aktive Aktuatoreinheit der Stelleinrichtung kann den Stützfedereinrichtungen grundsätzlich auf beliebige geeignete Weise funktionell, insbesondere räumlich, zugeordnet sein. Bevorzugt geschieht dies natürlich in Abstimmung auf ein zu erwartendes Kriech- bzw. Setzverhalten der Stützfedereinrichtungen. Besonders vorteilhaft ist es, wenn wenigstens einer der Stützfedereinrichtungen wenigstens eine aktive Aktuatoreinheit funktionell, insbesondere räumlich, zugeordnet ist. Eine besonders einfache Abstimmung mit einfacher bedarfsgerechter Kompensation von Kriech- bzw. Setzeffekten ist dann möglich, wenn mehreren der Stützfedereinrichtungen, insbesondere jeder der Stützfedereinrichtungen, jeweils wenigstens eine aktive Aktuatoreinheit, insbesondere genau eine aktive Aktuatoreinheit, funktionell zugeordnet ist.

Bei bestimmten vorteilhaften Varianten umfasst wenigstens eine aktive Aktuatoreinheit wenigstens einen Reluktanzaktuator mit einer ersten Magnetkreiskomponente und einer zweiten Magnetkreiskomponente, die einander zum berührungslosen Zusammenwirken zugeordnet sind. Dabei kann die erste Magnetkreiskomponente mechanisch mit der ersten Stützstruktur verbunden sein und die zweite Magnetkreiskomponente mechanisch mit der zweiten Stützstruktur verbunden sein. Zusätzlich oder alternativ kann eine der Magnetkreiskomponenten, insbesondere die erste Magnetkreiskomponente, eine Spuleneinheit umfassen, die zur Erzeugung eines Magnetfeldes in dem Reluktanzaktuator mit einer Spannungsquelle verbindbar ist. Hiermit ist es in besonders einfacher Weise möglich, den magnetischen Fluss im Magnetkreis und damit die Stellkraft anzupassen.

Der Reluktanzaktuator kann grundsätzlich auf beliebige Weise gestaltet sein. So kann er beispielsweise nach Art eines Hubmagneten gestaltet sein, bei dem der Beitrag zu der Stellkraft daraus resultiert, dass ein Magnetkreis des Reluktanzaktuators danach trachtet, wenigstens einen Luftspalt des Magnetkreises zu reduzieren. Ein solcher Hubmagnet weist typischerweise einen Kraftverlauf auf, bei dem mit Erhöhung des Luftspaltes die Kraft abnimmt. Diese "negative" Steifigkeit kann bei bestimmten Varianten in Abstimmung mit den Stützfedereinrichtungen vorteilhaft genutzt werden, wie dies bereits beschrieben wurde. Besonders einfach und günstig gestaltete Varianten ergeben sich, wenn eine erste Magnetkerneinheit der ersten Magnetkreiskomponente und eine zweite Magnetkerneinheit der zweiten Magnetkreiskomponente unter Ausbildung zweier Luftspalte einen Magnetkern eines Magnetkreises des Reluktanzaktuators bilden. Der Reluktanzaktuator weist dabei dann einen Referenzzustand auf, in dem der Magnetkreis einen minimierten magnetischen Widerstand (also eine minimierte Reluktanz) aufweist. Weiterhin weist der Reluktanzaktuator einen Stellzustand auf, in dem der Reluktanzaktuator zumindest einen Beitrag zu der Stellkraft liefert. Der Reluktanzaktuator ist dabei derart ausgebildet, dass in der ersten Magnetkerneinheit und der zweiten Magnetkerneinheit ein Magnetfeld erzeugt wird, dessen Magnetfeldlinien in dem Referenzzustand die Luftspalte jeweils in einer Magnetfeldlinienrichtung durchtreten. Weiterhin ist der Reluktanzaktuator derart ausgebildet und angeordnet, dass die erste Magnetkerneinheit und die zweite Magnetkerneinheit in dem Stellzustand gegenüber dem Referenzzustand quer zu der Magnetfeldlinienrichtung zueinander ausgelenkt sind.

Bei bestimmten Varianten kann vorgesehen sein, dass die wenigstens eine aktive Aktuatoreinheit derart ausgebildet ist, dass der Beitrag der Aktuatoreinheit zu der Stellkraft mit zunehmender Relativlageänderung zumindest abschnittsweise proportional abnimmt. Zusätzlich oder alternativ kann die wenigstens eine aktive Aktuatoreinheit derart ausgebildet sein, dass der Beitrag der Aktuatoreinheit zu der Stellkraft mit zunehmender Relativlageänderung zumindest abschnittsweise überproportional abnimmt. Mit anderen Worten besitzt die Aktuatoreinheit eine negative Steifigkeit, womit in vorteilhafter Weise die Steifigkeit der Stützfedereinrichtungen zumindest teilweise ausgeglichen bzw. kompensiert werden kann. Hiermit ist es beispielsweise in vorteilhafter Weise möglich, Stützfedereinrichtungen zu verwenden, die eine höhere Steifigkeit aufweisen und damit in geringerem Maße Kriech- und Setzeffekten unterliegen. Die erhöhte Steifigkeit der Stützfedereinrichtungen kann dann durch die negative Steifigkeit der Aktuatoreinheit(en) kompensiert werden, sodass in Summe zumindest eine dennoch vergleichsweise niedrige Steifigkeit in den Entkopplungsfreiheitsgraden erzielt wird.

Zusätzlich oder alternativ kann die wenigstens eine aktive Aktuatoreinheit derart ausgebildet sein, dass der Beitrag der Aktuatoreinheit zu der Stellkraft mit zunehmender Relativlageänderung zumindest abschnittsweise im Wesentlichen konstant ist. Hiermit kann dann in diesem Bereich der Auslenkung die oben bereits beschriebene Steifigkeit nahe oder gleich Null realisiert werden.

Die wenigstens eine aktive Aktuatoreinheit kann grundsätzlich so gestaltet sein, dass sie bereits selbst die erforderliche Entkopplung in den (für die Abstützung der zweiten Stützstruktur) erforderlichen Entkopplungsfreiheitsgraden zur Verfügung stellt. Bei weiteren Varianten übt die wenigstens eine aktive Aktuatoreinheit im Betrieb in einer Stellkraftrichtung ihren Beitrag zu der Stellkraft auf die zweite Stützstruktur aus, wobei die wenigstens eine aktive Aktuatoreinheit über eine Entkopplungseinrichtung mechanisch mit einer der Stützstrukturen verbunden ist, insbesondere mit der zweiten Stützstruktur verbunden ist. Die die Entkopplungseinrichtung ist dann dazu ausgebildet, in wenigstens einem von der Stellkraftrichtung verschiedenen Entkopplungsfreiheitsgrad eine zumindest teilweise mechanische Entkopplung zwischen der Aktuatoreinheit und der Stützstruktur zu erzeugen. Dabei kann der wenigstens eine Entkopplungsfreiheitsgrad ein translatorischer Freiheitsgrad sein, der quer zu der Stellkraftrichtung verläuft. Zusätzlich oder alternativ kann der wenigstens eine Entkopplungsfreiheitsgrad ein rotatorischer Freiheitsgrad um eine Achse sein, die quer zu der Stellkraftrichtung verläuft. In allen diesen Fällen kann auf einfache Weise eine günstige Schwingungsentkopplung erzielt werden.

Bei bestimmten besonders einfach zu realisierenden Varianten übt die wenigstens eine aktive Aktuatoreinheit im Betrieb in einer Stellkraftrichtung ihren Beitrag zu der Stellkraft auf eine der Stützstrukturen aus, wobei die wenigstens eine aktive Aktuatoreinheit über eine Entkopplungseinrichtung, die sich in der Stellkraftrichtung erstreckt, mechanisch mit der Stützstruktur verbunden ist. Dabei kann die Entkopplungseinrichtung ein in der Stellkraftrichtung langgestrecktes biegeweiches Entkopplungselement umfassen, um in einfacher Weise die Entkopplung zu erzielen. Zusätzlich oder alternativ kann die Entkopplungseinrichtung ein in der Stellkraftrichtung langgestrecktes Blattfederelement umfassen, um in einfacher Weise die Entkopplung zu erzielen. Zusätzlich oder alternativ kann die Entkopplungseinrichtung ein in der Stellkraftrichtung langgestrecktes und schlankes, insbesondere biegeweiches, Stabfederelement umfassen, um in einfacher Weise die Entkopplung zu erzielen.

Bei bevorzugten Varianten ist eine Steuereinrichtung vorgesehen, die dazu ausgebildet ist, in einem Kriechkompensationsmodus in Abhängigkeit von der Längenänderung der wenigstens einen Stützfedereinrichtung entlang ihrer Stützkraftrichtung die Stelleinrichtung zur Änderung der Stellkraft anzusteuern. Die Längenänderung der wenigstens einen Stützfedereinrichtung kann dabei auf beliebige geeignete Weise ermittelt werden. So können eine oder mehrere beliebige geeignete Erfassungsgrößen über entsprechende Erfassungseinrichtungen erfasst werden, die Rückschlüsse auf die Längenänderung ermöglichen. Ebenso kann die Steuereinrichtung zusätzlich oder alternativ zur Ermittlung der Längenänderung der wenigstens einen Stützfedereinrichtung entlang ihrer Stützkraftrichtung ein das Kriechverhalten der Stützfedereinrichtung beschreibendes Kriechmodell der Stützfedereinrichtung verwenden.

Bei bestimmten Varianten sind eine Erfassungseinrichtung und eine Steuereinrichtung vorgesehen, wobei die Erfassungseinrichtung dazu ausgebildet ist, wenigstens einen für die Relativlage zwischen der ersten Stützstruktur und der zweiten Stützstruktur in wenigstens einem Korrekturfreiheitsgrad repräsentativen Relativlageerfassungswert zu erfassen und an die Steuereinrichtung auszugeben. Die Steuereinrichtung ist dazu ausgebildet, in einem Kriechkompensationsmodus in Abhängigkeit von dem Relativlageerfassungswert, insbesondere in Abhängigkeit von einer zeitlichen Änderung des Relativlageerfassungswerts, die Stelleinrichtung zur Änderung der Stellkraft anzusteuern.

Das Ändern der Stellkraft in einem Kriechkompensationsmodus kann grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung etc.) erfolgen.

Bei bestimmten Varianten ist die Steuereinrichtung dazu ausgebildet, den Kriechkompensationsmodus zu aktivieren, wenn eine die durch eine Relativlageänderungsinformation bzw. einen Relativlageerfassungswert repräsentierte Relativlageänderung einen vorgebbaren Grenzwert überschreitet. Hiermit kann natürlich besonders effizient und bedarfsgerecht auf die Kriech- bzw. Setzeffekte reagiert werden. Dabei kann je nach Wahl des Grenzwerts ein diskretes Aktivieren (von Zeit zu Zeit) des Kriechkompensationsmodus realisiert sein. Ebenso kann letztlich aber auch eine kontinuierliche Regelung realisiert sein, mithin also der Kriechkompensationsmodus dauerhaft aktiv sein.

Zusätzlich oder alternativ kann die Steuereinrichtung dazu ausgebildet sein, den Kriechkompensationsmodus in Abhängigkeit von vorgebbaren Ereignissen, insbesondere in vorgebbaren zeitlichen Intervallen, zu aktivieren, wobei der Kriechkompensationsmodus insbesondere 1 µs bis 10 Jahre, vorzugsweise 1 ms bis 3 Jahre, weiter vorzugsweise 10 Minuten bis 1 Jahr, nach einem Betriebsbeginn der Abbildungseinrichtung und/oder einer vorhergehenden Aktivierung des Kriechkompensationsmodus aktiviert wird.

Die Steuereinrichtung kann grundsätzlich auf beliebige geeignete Weise gestaltet sein, eine dem jeweiligen optischen Abbildungsprozess angepasste Ansteuerung der Stelleinrichtung zu realisieren. Dabei können insbesondere beliebige geeignete Regelbandbreiten für die Ansteuerung der Stelleinrichtung vorgesehen sein. Bei besonders vorteilhaften Varianten weist die Steuereinrichtung eine Regelbandbreite von 0,5 µHz bis 500 Hz, vorzugsweise 0,01 Hz bis 100 Hz, weiter vorzugsweise 0,1 Hz bis 10 Hz, auf.

Bei dem Freiheitsgrad bzw. den Freiheitsgraden, in denen eine für den Abbildungsprozess bzw. dessen Abbildungsfehler relevante Relativlageänderung durch Kriech- bzw. Setzeffekte erfolgt, kann es sich um beliebige Freiheitsgrade bis hin zu allen sechs Freiheitsgraden im Raum handeln. Dabei können beliebige geeignete Grenzwerte vorgegeben sein, bei deren Überschreitung die Änderung der Stellkraft erforderlich bzw. vorgenommen wird.

Bei bestimmten Varianten ist der wenigstens eine Freiheitsgrad der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur und der zweiten Stützstruktur von einer vorgebbaren Relativsolllage um 0,1 µrad bis 1000 µrad, vorzugsweise 1 µrad bis 200 µrad, weiter vorzugsweise 10 µrad bis 100 µrad, repräsentativ. Zusätzlich oder alternativ kann der wenigstens eine Freiheitsgrad der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur und der zweiten Stützstruktur von einer vorgebbaren Relativsolllage um 0,1 µm bis 1000 µm, vorzugsweise 1 µm bis 200 µm, weiter vorzugsweise 10 µm bis 100 µm, repräsentativ.

Die vorliegenden Erfindung betrifft weiterhin eine optische Abbildungseinrichtung, insbesondere für die Mikrolithographie, mit einer Beleuchtungseinrichtung (102) mit einer ersten optischen Elementgruppe, einer Objekteinrichtung zur Aufnahme eines Objekts, einer Projektionseinrichtung mit einer zweiten optischen Elementgruppe und einer Bildeinrichtung, wobei die Beleuchtungseinrichtung zur Beleuchtung des Objekts ausgebildet ist und die Projektionseinrichtung zur Projektion einer Abbildung des Objekts auf die Bildeinrichtung ausgebildet ist. Die Beleuchtungseinrichtung und/oder die Projektionseinrichtung umfasst wenigstens eine erfindungsgemäße Anordnung. Hiermit lassen sich die oben beschriebenen Varianten und Vorteile in demselben Maße realisieren, sodass insoweit auf die obigen Ausführungen Bezug genommen wird.

Die vorliegenden Erfindung betrifft weiterhin ein Verfahren für eine optische Abbildungseinrichtung für die Mikrolithographie, insbesondere für die Verwendung von Licht im extremen UV-Bereich (EUV), bei dem eine erste Stützstruktur eine zweite Stützstruktur über eine Mehrzahl von Stützfedereinrichtungen einer Schwingungsentkopplungseinrichtung abstützt und dazu ausgebildet ist, wenigstens ein optisches Element der Abbildungseinrichtung abzustützen, wobei die Stützfedereinrichtungen kinematisch parallel zueinander zwischen der ersten Stützstruktur und der zweiten Stützstruktur wirken. Jede der Stützfedereinrichtungen definiert eine Stützkraftrichtung, in der sie eine Stützkraft zwischen der ersten Stützstruktur und der zweiten Stützstruktur ausübt, sowie eine Stützlänge entlang der Stützkraftrichtung. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Es wird eine Änderung einer statischen Relativlage zwischen der ersten Stützstruktur und der zweiten Stützstruktur in wenigstens einem Freiheitsgrad in einem Kompensationsschritt zumindest teilweise kompensiert, wobei die Relativlageänderung insbesondere durch eine Längenänderung wenigstens einer der Stützfedereinrichtungen entlang ihrer Stützkraftrichtung bedingt ist, die sich aus einem Kriechprozess der Stützfedereinrichtung ergibt. Dabei wird kinematisch parallel zu den Stützfedereinrichtungen zwischen der ersten Stützstruktur und der zweiten Stützstruktur eine Stellkraft auf die zweite Stützstruktur ausgeübt, wobei die Stellkraft zur zumindest teilweisen Kompensation der Relativlageänderung verändert wird. Hiermit lassen sich die oben beschriebenen Varianten und Vorteile ebenfalls in demselben Maße realisieren, sodass insoweit auf die obigen Ausführungen Bezug genommen wird.

Zur Erzeugung der Stellkraft wird bevorzugt wenigstens eine aktive Aktuatoreinheit mit einem Reluktanzaktuator und/oder wenigstens eine aktive Aktuatoreinheit mit einem Lorentz-Aktuator verwendet. Weiterhin kann die Stellkraft die Stützfedereinrichtungen zumindest teilweise entlasten und die Stellkraft zur zumindest teilweisen Kompensation der Relativlageänderung erhöht werden. Alternativ kann die Stellkraft die Stützfedereinrichtungen vorspannen und die Stellkraft zur zumindest teilweisen Kompensation der Relativlageänderung verringert werden.

Weitere Aspekte und Ausführungsbeispiele der Erfindung ergeben sich aus den abhängigen Ansprüchen und der nachfolgenden Beschreibung bevorzugter Ausführungsbeispiele, die sich auf die beigefügten Figuren bezieht. Alle Kombinationen der offenbarten Merkmale, unabhängig davon, ob diese Gegenstand eines Anspruchs sind oder nicht, liegen im Schutzbereich der Erfindung.

### KURZE BESCHREIBUNG DER ZEICHNUNGEN

- Figur 1: ist eine schematische Darstellung einer bevorzugten Ausführung einer erfindungsgemäßen optischen Abbildungseinrichtung, die eine bevorzugte Ausführung einer erfindungsgemäßen optischen Anordnung umfasst.
- Figur 2: ist eine schematische Ansicht eines Teils der Abbildungseinrichtung aus Figur 1 in einem ersten Zustand.
- Figur 3: ist eine schematische Ansicht des Teils der Abbildungseinrichtung aus Figur 2 in einem zweiten Zustand.
- Figur 4: ist eine schematische Ansicht des Teils einer Variante der Abbildungseinrichtung aus Figur 2.
- Figur 5: ist eine schematische Ansicht des Teils einer weiteren Variante der Abbildungseinrichtung aus Figur 2.
- Figur 6: ist eine schematische Ansicht des Teils einer weiteren Variante der Abbildungseinrichtung aus Figur 2.
- Figur 7: ist eine schematische Ansicht des Teils einer weiteren Variante der Abbildungseinrichtung aus Figur 2.
- Figur 8: ist ein Ablaufdiagramm eines bevorzugten Ausführungsbeispiels eines erfindungsgemäßen Verfahrens, das mit der Abbildungseinrichtung aus Figur 1 durchgeführt werden kann.

### DETAILLIERTE BESCHREIBUNG DER ERFINDUNG

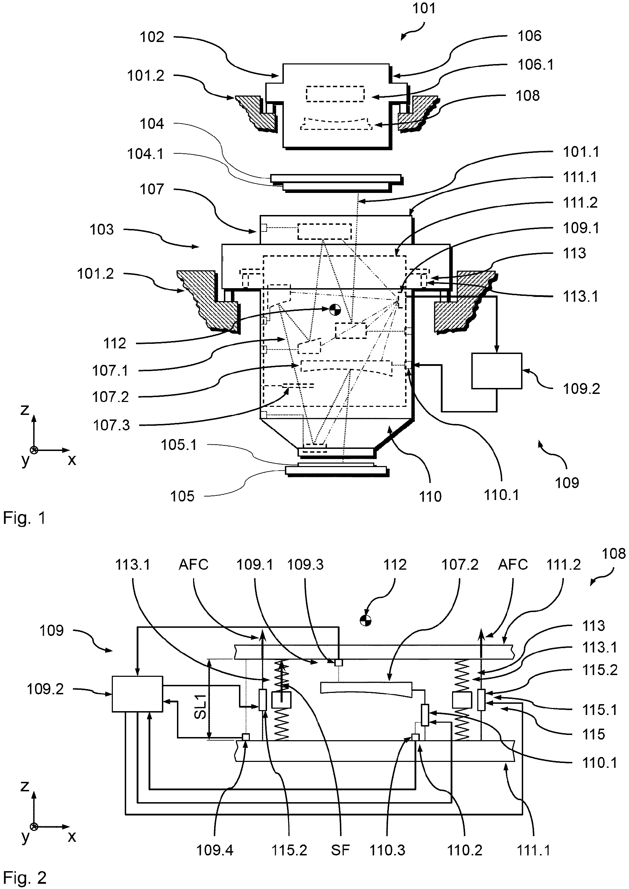

Im Folgenden werden unter Bezugnahme auf die Figuren 1 bis 8 bevorzugte Ausführungsbeispiele einer erfindungsgemäßen optischen Abbildungseinrichtung in Form einer Projektionsbelichtungsanlage 101 für die Mikrolithographie beschrieben, die bevorzugte Ausführungsbeispiele einer erfindungsgemäßen optischen Anordnung umfassen. Zur Vereinfachung der nachfolgenden Ausführungen wird in den Zeichnungen ein x,y,z-Koordinatensystem angegeben, wobei die z-Richtung entgegen der Richtung der Gravitationskraft verläuft. Selbstverständlich ist es in weiteren Ausgestaltungen möglich, beliebige davon abweichende Orientierungen eines x,y,z-Koordinatensystems zu wählen.

Figur 1 ist eine schematische, nicht maßstabsgetreue Darstellung der Projektionsbelichtungsanlage 101, die in einem Mikrolithographieprozess zur Herstellung von Halbleiterbauelementen verwendet wird. Die Projektionsbelichtungsanlage 101 umfasst eine Beleuchtungseinrichtung 102 und eine Projektionseinrichtung 103. Die Projektionseinrichtung 103 ist dazu ausgebildet, in einem Belichtungsprozess ein Bild einer Struktur einer Maske 104.1, die in einer Maskeneinheit 104 angeordnet ist, auf ein Substrat 105.1 zu übertragen, das in einer Substrateinheit 105 angeordnet ist. Dazu beleuchtet die Beleuchtungseinrichtung 102 die Maske 104.1. Die optische Projektionseinrichtung 103 empfängt das Licht von der Maske 104.1 und projiziert das Bild der Maskenstruktur der Maske 104.1 auf das Substrat 105.1, wie z.B. einen Wafer oder dergleichen.

Die Beleuchtungseinrichtung 102 umfasst eine optische Einheit 106 mit einer optischen Elementgruppe 106.1. Die Projektionseinrichtung 103 umfasst eine weitere optische Einheit 107 mit einer optischen Elementgruppe 107.1. Die optischen Elementgruppen 106.1, 107.1 sind entlang eines gefalteten Mittenstrahlverlaufs 101.1 der Projektionsbelichtungsanlage 101 angeordnet. Jede der optischen Elementgruppen 106.1, 107.1 kann eine beliebige Vielzahl optischer Elemente umfassen.

In dem vorliegenden Ausführungsbeispiel arbeitet die Projektionsbelichtungsanlage 101 mit Nutzlicht im EUV-Bereich (extrem ultraviolette Strahlung), mit Wellenlängen zwischen 5 nm bis 20 nm, insbesondere mit einer Wellenlänge von 13 nm. Bei den optischen Elementen der Elementgruppen 106.1, 107.1 der Beleuchtungseinrichtung 102 und der Projektionseinrichtung 103 handelt es sich daher ausschließlich um reflektive optische Elemente. Die optischen Elementgruppen 106.1, 107.1 können ein oder mehrere erfindungsgemäße optischen Anordnungen umfassen, wie dies nachfolgend anhand der optischen Anordnung 108 beschrieben wird. Die optischen Einheiten 106 und 107 sind jeweils über eine Basisstruktur 101.2 abgestützt.

In weiteren Ausgestaltungen der Erfindung ist es (insbesondere in Abhängigkeit von der Wellenlänge des Beleuchtungslichts) selbstverständlich auch möglich, für die optischen Module jede Art von optischen Elementen (refraktiv, reflektiv, diffraktiv) alleine oder in beliebiger Kombination einzusetzen.

Die erfindungsgemäße Anordnung wird im Folgenden beispielhaft anhand der Anordnung 108 beschrieben, die ein Teil der Projektionseinrichtung 103 ist. Bei der Abbildungseinrichtung 101 bestehen unter anderem sehr strenge Anforderungen hinsichtlich der Position und/oder Orientierung der optischen Elemente der optischen Elementgruppe 107.1 der Projektionseinrichtung 103 relativ zueinander, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten. Als Konsequenz müssen die optischen Elemente der optischen Elementgruppe 107.1 in einer wohldefinierten Weise abgestützt werden, um eine vorgegebene wohldefinierte räumliche Beziehung zwischen den optischen Elementen der Elementgruppe 107.1 und den übrigen optischen Komponenten einzuhalten und so letztlich eine möglichst hohe Abbildungsqualität zu erreichen.

Hierzu wird im vorliegenden Beispiel eine Messung der Lage (also der Position und/oder Orientierung) der optischen Elemente der Elementgruppe 107.1 mittels einer (in Figur 1 nur sehr vereinfacht dargestellten) Messeinrichtung 109.1 einer Steuereinrichtung 109 vorgenommen. Die Messeinrichtung 109.1 liefert ihre Messsignale LMS an eine Steuereinheit 109.2 der Steuereinrichtung 109. Die Steuereinheit 109.2 steuert dann in Abhängigkeit von den Messsignalen LMS der Messeinrichtung 109.1 eine Lageregeleinrichtung 110 an, die auf einer lasttragenden ersten Struktur 111.1 abgestützt ist. Über die Lageregeleinrichtung 110 wird dann die Lage jedes der optischen Elemente der Elementgruppe 107.1 bezüglich einer zentralen Referenz 112 aktiv mit der für den Abbildungsprozess erforderlichen Präzision (typischerweise im Bereich von 1 nm und darunter) und Regelbandbreite (typischerweise bis zu 200 Hz) eingestellt.

Im vorliegenden Beispiel gibt die Messeinrichtung 109.1 eine Messinformation MI an die Lageregeleinrichtung 110 aus, die für die jeweiligen Position und/oder Orientierung des jeweiligen optischen Elements der Elementgruppe 107.1 bezüglich der Referenz 112 in wenigstens einem Freiheitsgrad im Raum repräsentativ ist. Im Zustand bei der erstmaligen Inbetriebnahme der Abbildungseinrichtung 101 (in dem sich die Abbildungseinrichtung 101 in einem ersten Betriebszustand OM1 befindet) steuert die Steuereinheit 109.2 somit die Lageregeleinrichtung 110 in Abhängigkeit von der Messinformation MI entsprechend an, um einen ersten Sollzustand S1 der Position und/oder Orientierung der optische Elemente der Elementgruppe 107.1 bezüglich der Referenz 112 zu erzeugen, wie es in Figur 2 für ein optisches Element 107.2 der Elementgruppe 107.1 dargestellt ist.

Ein wesentlicher Faktor für die erzielbare Abbildungsqualität der Abbildungseinrichtung 101 ist die Präzision der Messung der Messeinrichtung 109.1, die wiederum von einer möglichst stabilen und präzisen Abstützung der Messeinrichtung 109.1 abhängt. Diese Abstützung sollte dabei nach Möglichkeit sicherstellen, dass die Komponenten der Messeinrichtung 109.1 eine wohldefinierte Lage (d. h. Position und/oder Orientierung) bezüglich der zentralen Referenz 112 aufweisen, auf die das Messergebnis der Messeinrichtung 109.1 bezogen wird.

Hierzu sind die Messeinheiten 109.3 der Messeinrichtung 109.1 auf einer separaten zweiten Stützstruktur 111.2 abgestützt, die häufig auch als Sensor-Rahmen bezeichnet wird. Der Sensor-Rahmen 111.2 ist seinerseits der (ein- oder mehrteiligen) lasttragenden ersten Struktur 111.1 abgestützt. Hierdurch kann sichergestellt werden, dass der Sensor-Rahmen 111.2 weit gehend von den Stützlasten für die optischen Elemente der Elementgruppe 107.1 frei gehalten werden kann.

Um den Sensor-Rahmen 111.2 möglichst weitgehend frei von inneren Störungen der Abbildungseinrichtung 101 (z. B. durch bewegte Komponenten induzierte Vibrationen) und äußeren Störungen (z. B. unerwünschte Erschütterungen) zu halten, ist der Sensor-Rahmen 111.2 über eine Schwingungsentkopplungseinrichtung 113 schwingungsisoliert bzw. schwingungsentkoppelt auf der lasttragenden Struktur 111.1 abgestützt. Dies geschieht über eine Mehrzahl von Stützfedereinrichtungen 113.1 der Schwingungsentkopplungseinrichtung 113, wobei die Stützfedereinrichtungen 113.1 kinematisch parallel zueinander zwischen der lasttragenden ersten Stützstruktur 111.1 und dem Sensor-Rahmen 111.2 wirken. Jede der Stützfedereinrichtungen 113.1 definiert eine Stützkraftrichtung SFR, in der sie eine Stützkraft SF zwischen der ersten Stützstruktur 111.1 und der zweiten Stützstruktur 111.2 ausübt, sowie eine Stützlänge SL1 entlang der Stützkraftrichtung SFR.

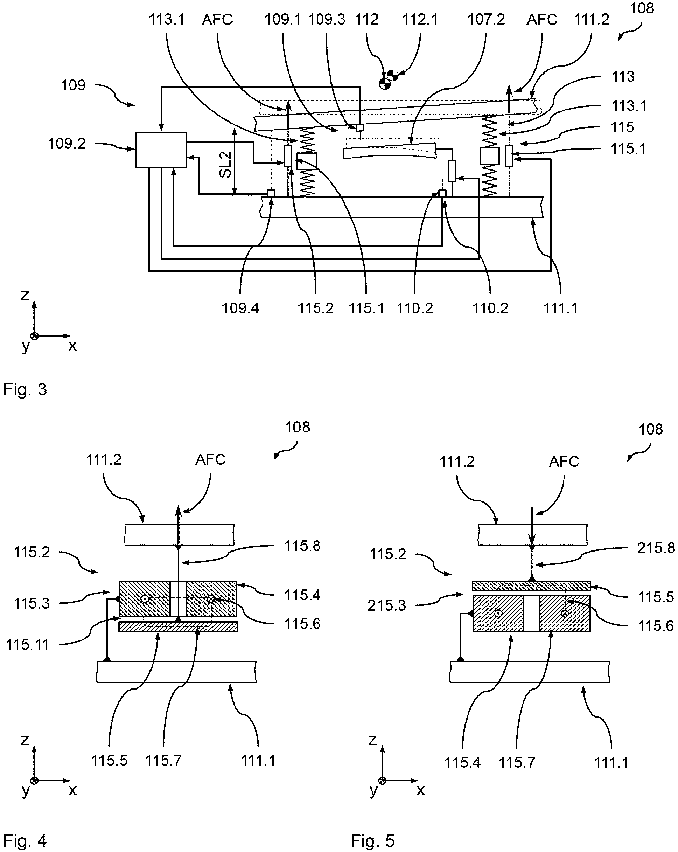

Während hiermit (auf kurzen Zeitskalen) eine gute dynamische Schwingungsisolierung bzw. Schwingungsentkopplung des Sensor-Rahmens 111.2 von der lasttragenden ersten Stützstruktur 111.1 erreicht werden kann, hat es sich jedoch gezeigt, dass es auf langen Zeitskalen im Bereich der Schwingungsentkopplungseinrichtung 113, insbesondere im Bereich der Stützfedereinrichtungen 113.1, zu so genannten Kriecheffekten bzw. Setzeffekten kommen kann. Hierdurch ändert sich langfristig die Stützlänge der Stützfedereinrichtungen 113.1 (wie dies in Figur 3 und 4 durch die Länge SL2 angedeutet ist) und damit sowohl die Lage des Sensor-Rahmens 111.2 als auch die Lage der für die Ansteuerung der Lageregeleinrichtung 110 verwendeten Referenz 112 bezüglich der lasttragenden Struktur 111.1 (gegenüber der in Figur 3 durch die Kontur 112.1 angedeuteten Ausgangslage), wie dies (stark übertrieben) in Figur 3 dargestellt ist. Eine solche Lageänderung der Referenz 112 kann im Normalbetrieb der Abbildungseinrichtung 101 grundsätzlich durch die Lageregeleinrichtung 110 kompensiert werden, indem die optischen Elemente der Elementgruppe 107.1 der Referenz 112 nachgeführt werden (wie dies in Figur 3 dargestellt ist). Eine solche Kompensation der Lageänderung der Referenz 112 durch die Lageregeleinrichtung 110 über die Lebensdauer der Abbildungseinrichtung 101 würde jedoch ausreichende Verfahrwege, mithin also eine ausreichende Bewegungsreserve der Lageregeleinrichtung 110 erfordern, wodurch diese entsprechend aufwändig bzw. teuer gestaltet sein müsste.

Um dies zu vermeiden, ist im vorliegenden Beispiel eine Kriechkompensationseinrichtung 115 zur Kompensation einer solchen Änderung der statischen Relativlage zwischen der ersten Stützstruktur 111.1 und der zweiten Stützstruktur 111.2 in wenigstens einem Korrekturfreiheitsgrad vorgesehen. Die Kriechkompensationseinrichtung 115 umfasst eine kinematisch parallel zu den Stützfedereinrichtungen zwischen der ersten Stützstruktur und der zweiten Stützstruktur wirkende, ansteuerbare aktive Stelleinrichtung 115.1 mit einer Reihe von aktiven Aktuatoreinheiten 115.2, die von der Steuereinheit 109.2 angesteuert werden können. Die Stelleinrichtung 115.1 übt im vorliegenden Beispiel in dem ersten Betriebsmodus OM1 eine erste Stellkraft AFT1 auf die den Sensor-Rahmen 111.2 aus, welche die Resultierende der einzelnen Stellkraftbeiträge SFC der aktiven Aktuatoreinheiten 115.2 ist. Wie nachfolgend noch näher erläutert wird, wird die Stellkraft AFT zur Kompensation der Relativlageänderung seitens der Steuereinheit verändert.

Hierzu erfasst die Steuereinrichtung 109 im vorliegenden Beispiel eine für eine Änderung der statischen Relativlage zwischen der lasttragenden ersten Stützstruktur 110.1 und der zweiten Stützstruktur 110.2 in wenigstens einem Freiheitsgrad repräsentative Relativlageänderungsinformation RSCI. Die Steuereinrichtung 109 weist einen Kriechkompensationsmodus CCM auf, in dem die aktive Stelleinrichtung 115.1 von der Steuereinheit 109.2 angesteuert wird, um die Stellkraftbeiträge SFC der aktiven Aktuatoreinheiten 115.2 und damit die Stellkraft AFT in Abhängigkeit von der Relativlageänderungsinformation RSCI in eine zweite Stellkraft AFT2 zu ändern. Die zweite Stellkraft AFT2 ist dabei so gewählt, dass der Sensor-Rahmen 111.2 wieder in den in Figur 2 dargestellten Ausgangszustand verbracht wird. Die aktive Stelleinrichtung 115.1 übt dann in einem dem Kriechkompensationsmodus CCM nachfolgenden zweiten Betriebsmodus OM2 die zweite Stellkraft AFT2 auf die den Sensor-Rahmen 111.2 aus.

Es versteht sich, dass für die Ansteuerung der Stelleinrichtung 115.1 sowohl ein geschlossener Regelkreis realisiert sein kann (bei dem die Relativlageänderungsinformation RSCI über entsprechende Erfassungssignale tatsächlich erfasst wird) als auch eine offene Steuerstrecke realisiert sein kann (bei dem die Relativlageänderungsinformation RSCI beispielsweise über ein entsprechendes Modell ermittelt wird), wie dies nachfolgend noch näher erläutert wird.

Mit dieser Korrektur bzw. Kompensation ist es zum Beispiel in einfacher und vorteilhafter Weise möglich, den Sensor-Rahmen 111.2, die Referenz 12 und damit die Lageregeleinrichtung 110 (und die von ihr getragenen optischen Elemente der Elementgruppe 107.1, wie beispielsweise das optische Element 107.2) nach einer bestimmten längeren Betriebszeit (über die sich Kriech- oder Setzeffekte in der Abstützung der zweiten Stützstruktur 110.2 spürbar ausgewirkt haben) wieder in ihren Ausgangszustand (oder in dessen Nähe) zurückzusetzen, den sie nach einer initialen Justage der Abbildungseinrichtung (typischerweise unmittelbar bei erstmaliger Inbetriebnahme der Abbildungseinrichtung 101), mithin also in dem ersten Betriebszustand OM1 innehatte.

Hiermit ist es insbesondere in einfacher und vorteilhafter Weise möglich, den maximal erforderlichen bzw. möglichen Verfahrweg der Lageregeleinrichtung 110 vergleichsweise gering zu halten bzw. auf das Nötigste zu beschränken. Insbesondere ist keine große Bewegungsreserve für die Kompensation langfristiger Kriech- oder Setzeffekte durch die Lageregeleinrichtung 110 vorzuhalten. Diese Bewegungsreserve kann deutlich kleiner gehalten werden und sich beispielsweise auf einen für die Dauer des ersten Betriebsmodus OM1 zu erwartenden Wert beschränken.

Es versteht sich, dass das Ändern der Stellkraft AFT beliebig oft wiederholt werden kann, mithin also beliebig oft in den Kriechkompensationsmodus CCM geschaltet werden kann. Hiermit ist es möglich, über die gesamte Lebensdauer der Abbildungseinrichtung 101 ein entsprechend günstiges Betriebsverhalten zu erzielen.

Die Relativlageänderung bzw. die zugehörige Relativlageänderungsinformation RSCI kann grundsätzlich auf beliebige geeignete Weise ermittelt werden. So kann die Lageregeleinrichtung 110 beispielsweise eine mit der Steuereinheit 109.2 verbundene Auslenkungserfassungseinrichtung 110.2 umfassen. Die Auslenkungserfassungseinrichtung 110.2 erfasst eine Auslenkungsinformation DI, die für eine Auslenkung des optischen Elements 107.2 bezüglich der ersten Stützstruktur 111.1 in wenigstens einem Freiheitsgrad aus dem ersten Ausgangszustand repräsentativ ist. Die Steuereinrichtung 109 leitet aus der Auslenkungsinformation DI, insbesondere in Abhängigkeit von einer zeitlichen Änderung der Auslenkungsinformation DI, dann die Relativlageänderungsinformation RSCI ab.

So kann die Lageregeleinrichtung 110 zur aktiven Verstellung des optischen Elements 107.2 eine Reihe von Lageregelaktuatoren 110.1 umfassen, von denen aus Gründen der Übersichtlichkeit in den Figuren 2 und 3 jeweils nur ein Lageregelaktuator 110.1 dargestellt ist. Bei typischen Varianten sind mehrere Lageregelaktuatoren 110.1 vorgesehen, die nach Art einer Parallelkinematik zwischen der ersten Stützstruktur 111.1 und dem optischen Element 107.1 wirken. Beispielsweise können sechs Lageregelaktuatoren 110.1 vorgesehen sein, die nach Art einer Hexapod-Kinematik wirken.

Eine Auslenkungserfassungseinrichtung 110.2 kann beispielsweise eine Verstellinformation VI erfassen, die für eine Verstellung des jeweiligen Lageregelaktuators 110.1 aus dem justierten ersten Ausgangszustand repräsentativ ist. Die Steuereinrichtung 109.1 kann dann aus der Verstellinformation VI, insbesondere in Abhängigkeit von einer zeitlichen Änderung der Verstellinformation VI, die Relativlageänderungsinformation RSCI ableiten.

Weiterhin kann die Auslenkungserfassungseinrichtung 110.2 wenigstens einen Verstellsensor 110.3 umfassen, der dem jeweiligen Lageregelaktuator 110.1 zugeordnet ist. Der Verstellsensor 110.3 gibt eine für die Stellbewegung des Lageregelaktuators 110.1, insbesondere eine Längenänderung des Lageregelaktuators 110.1, repräsentative Verstellsensorinformation VSI aus. Die Steuereinrichtung 109 kann dann aus der Verstellsensorinformation VSI die Verstellinformation VI ableiten. Dabei versteht es sich, dass grundsätzlich beliebig viele Verstellsensoren 110.3 je Lageregelaktuator 110.1 vorgesehen sein können, um die Verstellinformation VI zu ermitteln. Im vorliegenden Beispiel sind dem jeweiligen Lageregelaktuator 110.1 wenigstens zwei Verstellsensoren 110.3 zugeordnet, da hiermit eine besonders zuverlässige, fehlertolerante Ermittlung der Verstellinformation VI möglich ist.

Es versteht sich jedoch, dass die Verstellinformation VI bei anderen Varianten (zusätzlich oder alternativ zu der Verwendung der Verstellsensoren 110.3) grundsätzlich auch auf beliebige andere geeignete Weise erfasst werden kann. So kann beispielsweise vorgesehen sein, beginnend mit dem ersten Ausgangszustand die Steuersignale für den jeweiligen einen Lageregelaktuator 110.2 lückenlos in einer Historie zu erfassen bzw. nachzuhalten und aus dieser Historie der Steuersignale die Verstellinformation VI zu ermitteln.

Bei bestimmten Varianten kann die Steuereinrichtung 109 gegebenenfalls auch eine (nicht näher dargestellte) Abbildungsfehlererfassungseinrichtung umfassen, die wenigstens eine für einen Abbildungsfehler der Abbildungseinrichtung repräsentative Abbildungsfehlerinformation IEI erzeugt. Die Steuereinrichtung 109 leitet dann aus der Abbildungsfehlerinformation IEI, insbesondere in Abhängigkeit von einer zeitlichen Änderung der Abbildungsfehlerinformation IEI, die Relativlageänderungsinformation RSCI. Diese Varianten nutzen in vorteilhafter Weise einen bekannten Zusammenhang zwischen dem Abbildungsfehler der Abbildungseinrichtung und der durch Kriech- bzw. Setzeffekte bedingten statischen Relativlageänderung zwischen der ersten Stützstruktur 111.1 und der zweiten Stützstruktur 111.2. So können bestimmte Relativlageänderungen charakteristische Abbildungsfehler hervorrufen, mithin also einen charakteristischen Fingerabdruck aufweisen, der zuvor theoretisch und/oder durch simulatorisch ermittelt wurde. Diese charakteristischen Abbildungsfehler bzw. Fingerabdrücke können dann genutzt werden, um im Betrieb in der Steuereinrichtung 109 auf eine tatsächliche Relativlageänderung zu schließen.

Ein besonders deutlicher Zusammenhang zwischen dem Abbildungsfehler und einer solchen Relativlageänderung ergibt sich insbesondere bei Varianten, bei denen die optische Abbildungseinrichtung 101 auch passive optische Komponenten umfasst, die an der Abbildung beteiligt sind, jedoch nicht aktiv über die Lageregeleinrichtung 110 eingestellt werden, sondern im Betrieb im Wesentlichen starr mit der ersten Stützstruktur 111.1 verbunden sind, wie dies in Figur 1 durch die Kontur 107.3 angedeutet ist, die eine Blende repräsentiert. In diesem Fall werden nur die aktiv eingestellten optischen Elemente der Elementgruppe 107.1 durch die Lageregeleinrichtung 110 der Relativlageänderung nachgeführt, während die passiven Komponenten, wie die Blende 107.3, in ihrer Lage verbleiben und sich damit eine Lageänderung zwischen den optischen Komponenten 107.1 und 107.3 ergibt, die einen charakteristischen Abbildungsfehler nach sich zieht.

Bei weiteren Varianten kann die Steuereinrichtung 109 zusätzlich oder alternativ eine Relativlageerfassungseinrichtung umfassen, wie sie in Figur 2 durch die Kontur 109.4 angedeutet ist. Die Relativlageerfassungseinrichtung 109.4 erzeugt dabei wenigstens eine für die Relativlage zwischen der ersten Stützstruktur 111.1 und der zweiten Stützstruktur 111.2 in wenigstens einem Freiheitsgrad repräsentative Relativlageinformation RSI, die an die Steuereinheit 109.2 ausgegeben wird. Die Steuereinrichtung 109 ist leitet dann aus der Relativlageinformation RSI, insbesondere in Abhängigkeit von einer zeitlichen Änderung der Relativlageinformation RSI, die Relativlageänderungsinformation RSCI ab. Hiermit kann eine besonders einfache und präzise Erfassung der Relativlageänderungsinformation RSCI realisiert werden.

Während die vorstehend beschriebenen Varianten jeweils einen geschlossenen Regelkreis realisieren, kann wie erwähnt auch eine Variante mit einer offenen Steuerstrecke realisiert sein. So kann bei bestimmten Varianten die Steuereinrichtung 109 bei bestimmten Varianten zur Ermittlung der Relativlageänderungsinformation RSCI auch ein Kriechmodell CM der Stützfedereinrichtung 113 verwenden, wobei das Kriechmodell CM der Stützfedereinrichtung 113 das Kriechverhalten der Stützfedereinrichtung 113 beschreibt. Aus diesem mit ausreichender Genauigkeit bekannten Kriechverhalten kann die Relativlageänderungsinformation RSCI dann gegebenenfalls ohne weitere Sensorik ermittelt werden und unmittelbar für die Ansteuerung verwendet werden. Bei weiteren Varianten kann das Kriechmodell CM aber auch für eine Plausibilitätsprüfung der Relativlageänderungsinformation RSCI verwendet werden, welche auf eine andere vorstehend oder nachfolgend beschriebene Weise ermittelt wurde.

Es sei an dieser Stelle nochmals erwähnt, dass die vorstehend oder nachfolgend beschriebenen Varianten zur Ermittlung der Relativlageänderungsinformation RSCI grundsätzlich auf beliebige Weise kombiniert werden können, um beispielsweise eine konsolidierte (beispielsweise gemittelte) Relativlageänderungsinformation RSCI zu erlangen. Zusätzlich oder alternativ können natürlich auch einzelne Varianten der Ermittlung der Relativlageänderungsinformation RSCI zur Plausibilitätsprüfung der Ergebnisse der anderen Varianten der Ermittlung der Relativlageänderungsinformation RSCI verwendet werden.

Die Änderung der Stellkraft AFT kann weiterhin grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung 101 etc.) erfolgen.

Im vorliegenden Beispiel aktiviert die Steuereinrichtung 109 den Kriechkompensationsmodus CCM, wenn die durch die Relativlageänderungsinformation RSCI repräsentierte Relativlageänderung einen vorgebbaren Grenzwert LIM überschreitet (d.h. wenn gilt: RSCI > LIM). Hiermit kann natürlich besonders effizient und bedarfsgerecht auf die Kriech- bzw. Setzeffekte reagiert werden.

Zusätzlich oder alternativ kann die Steuereinrichtung 109 den Kriechkompensationsmodus CCM wie erwähnt in Abhängigkeit von vorgebbaren Ereignissen, insbesondere in vorgebbaren zeitlichen Intervallen, aktivieren, wobei der Kriechkompensationsmodus insbesondere 1 µs bis 10 Jahre, vorzugsweise 1 ms bis 3 Jahre, weiter vorzugsweise 10 Minuten bis 1 Jahr, nach einem Betriebsbeginn der Abbildungseinrichtung 101 und/oder einer vorhergehenden Antivierung des Kriechkompensationsmodus CCM aktiviert wird.

Die Steuereinrichtung 109 kann grundsätzlich auf beliebige geeignete Weise gestaltet sein, eine dem jeweiligen optischen Abbildungsprozess der Abbildungseinrichtung 101 angepasste Ansteuerung der Lageregeleinrichtung 110 zu realisieren. Dabei können beliebige geeignete Regelbandbreiten für die Ansteuerung der Lageregeleinrichtung 110 vorgesehen sein. Bei besonders vorteilhaften Varianten weist die Steuereinrichtung 109 eine Regelbandbreite von 0,5 µHz bis 500 Hz, vorzugsweise 0.01 Hz bis 100 Hz, weiter vorzugsweise 0,1 Hz bis 10 Hz, auf.

Bei dem Freiheitsgrad bzw. den Freiheitsgraden DOF, in denen eine für den Abbildungsprozess bzw. dessen Abbildungsfehler relevante Relativlageänderung durch Kriech- bzw. Setzeffekte erfolgt, kann es sich um beliebige Freiheitsgrade bis hin zu allen sechs Freiheitsgraden im Raum handeln. Dabei können beliebige geeignete Grenzwerte vorgegeben sein, bei deren Überschreitung ein Ersatz des bisherigen Sollzustands S1 durch den korrigierten Sollzustand S2 erforderlich bzw. vorgenommen wird.

Bei bestimmten Varianten ist der wenigstens eine Freiheitsgrad DOF der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 0,1 µrad bis 1000 µrad, vorzugsweise 1 µrad bis 200 µrad, weiter vorzugsweise 10 µrad bis 100 µrad, repräsentativ. Zusätzlich oder alternativ kann der wenigstens eine Freiheitsgrad DOF der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 0,1 µm bis 1000 µm, vorzugsweise 1 µm bis 200 µm, weiter vorzugsweise 10 µm bis 100 µm, repräsentativ.

Die Stelleinrichtung 115.1 kann grundsätzlich auf beliebige geeignete Weise gestaltet sein, um die Stellkraft AFT zu erzeugen. Bevorzugt ist die Steifigkeit der Stelleinrichtung 115.1 natürlich auf die Steifigkeit der Stützfedereinrichtungen 113.1 abgestimmt, um die gewünschte Entkopplungswirkung der Schwingungsentkopplungseinrichtung 113 in den erforderlichen Entkopplungsfreiheitsgraden zu erzielen. Bevorzugt ist die Stelleinrichtung 115.1 so gestaltet, dass sie in diesen Entkopplungsfreiheitsgraden, in denen die Schwingungsentkopplungseinrichtung 113 eine Entkopplung bereitstellen soll, einen möglichst geringen Beitrag zur Steifigkeit der Abstützung der Sensor-Rahmens 111.2 liefert. Vorzugsweise liefert die Stelleinrichtung 115.1 in diesen Entkopplungsfreiheitsgraden im Wesentlichen keinen Beitrag zur Steifigkeit der Abstützung des Sensor-Rahmens 111.2.

Das Zusammenspiel zwischen den Stützfedereinrichtungen 113.1 und der Stelleinrichtung 115.1 kann grundsätzlich auf beliebige geeignete Weise gestaltet sein, um die gewünschte schwingungsentkoppelte Abstützung des Sensor-Rahmens 111.2 zu erzielen. So kann die Stelleinrichtung 115.1 derart ausgebildet sein, dass die Stellkraft AFT die Stützfedereinrichtungen 113.1 zumindest teilweise entlastet und die Stell kraft AFT zur zumindest teilweisen Kompensation der Relativlageänderung erhöht wird, wie dies nachfolgend noch im Zusammenhang mit den Figuren 4 und 6 beschrieben wird. Ebenso kann die Stelleinrichtung 115.1 aber auch derart ausgebildet sein, dass die Stellkraft AFT die Stützfedereinrichtungen 113.1 vorspannt und die Stell kraft AFT zur zumindest teilweisen Kompensation der Relativlageänderung verringert wird, wie dies nachfolgend noch im Zusammenhang mit den Figuren 5 und 7 beschrieben wird.

Bei den Varianten der Figuren 4 und 6 ist die Stelleinrichtung 115.1 zur Entlastung der Stützfedereinrichtungen 113.1 derart ausgebildet, dass die Stellkraft AFT wenigstens einen Anteil der Gesamtgewichtskraft des Sensor-Rahmens 111.2 und der davon getragenen Komponenten (wie der Messeinrichtung 109.1) ausgleicht. Besonders vorteilhaft ist es, wenn dieser Anteil wenigstens 0,1% bis 30%, vorzugsweise wenigstens 0,5% bis 6%, weiter vorzugsweise wenigstens 1% bis 3%, der Gesamtgewichtskraft beträgt. Dabei kann es insbesondere günstig sein, wenn zumindest ein Großteil der Gewichtskraft durch die Stellkraft AFT aufgenommen wird, die Stützfedereinrichtungen 113.1 mithin also von den statischen Lasten erheblich entlastet werden und es aufgrund dieser Entlastung auch zu verringerten Kriech- bzw. Setzeffekten kommt.

Die wenigstens eine aktive Aktuatoreinheit 115.2 der Stelleinrichtung 115.1 kann den Stützfedereinrichtungen 113.1 grundsätzlich auf beliebige geeignete Weise funktionell, insbesondere räumlich, zugeordnet sein. Bevorzugt geschieht dies natürlich in Abstimmung auf ein zu erwartendes Kriech- bzw. Setzverhalten der Stützfedereinrichtungen 113.1. Besonders vorteilhaft ist es, wenn wie im vorliegenden Beispiel jeder der Stützfedereinrichtungen 113.1 eine aktive Aktuatoreinheit 115.2 räumlich und damit auch funktionell zugeordnet ist. Hiermit ist eine besonders einfache Abstimmung mit einfacher bedarfsgerechter Kompensation von Kriech- bzw. Setzeffekten möglich.

Zur Erzeugung der Stellkraft AFT können grundsätzlich beliebige geeignete Aktuatoreinheiten 115.2 verwendet werden. So kann die Stelleinrichtung auch wenigstens eine aktive Aktuatoreinheit 115.2 mit einem Lorentz-Aktuator umfassen. Diese haben insbesondere den Vorteil, dass sie über einen gewissen Stellbereich entlang ihrer Stellkraftrichtung eine Steifigkeit aufweisen, die zumindest im Wesentlichen gleich Null ist.

Bei den nachfolgend im Zusammenhang mit den Figuren 4 bis 7 beschriebenen Beispielen umfasst die Stelleinrichtung 115.1 jedoch jeweils eine Reihe von aktiven Aktuatoreinheiten 115.2 mit einem Reluktanzaktuator 115.3, 215.3, 315.3, 415.3. Diese Reluktanzaktuatoren 115.3 bis 415.3 haben gegenüber Lorentz-Aktuatoren insbesondere den Vorteil, dass sie bei vergleichsweise geringerem Bauraum und bei vergleichsweise geringerer Wärmeentwicklung eine vergleichsweise hohe Stellkraft erzeugen können. Darüber hinaus besitzen die Reluktanzaktuatoren 115.3 und 215.3 bei Erhöhung des Luftspalts eine negative Steifigkeit, während die Reluktanzaktuatoren 315.3 und 415.3 bei Auslenkung aus ihrer Ruhelage (d.h. der Lage mit minimierter Reluktanz) über einen gewissen Stellbereich eine Steifigkeit aufweisen, die zumindest im Wesentlichen gleich Null ist. Beides kann in entsprechender Abstimmung mit den Stützfedereinrichtungen 113.1 von Vorteil sein.

Wie nachfolgend zunächst anhand der Variante aus Figur 4 beschrieben wird, umfasst die aktive Aktuatoreinheit 115.2 wenigstens einen Reluktanzaktuator 115.3 mit einer ersten Magnetkreiskomponente 115.4 und einer zweiten Magnetkreiskomponente 115.5, die einander zum berührungslosen Zusammenwirken zugeordnet sind. Dabei ist die erste Magnetkreiskomponente 115.4 mechanisch mit der lasttragenden ersten Stützstruktur 111.1 verbunden, während die zweite Magnetkreiskomponente 115.5 mechanisch mit dem Sensor-Rahmen 111.2 verbunden ist. Die erste Magnetkreiskomponente 115.4 umfasst dabei eine Spuleneinheit 115.6, die zur Erzeugung eines durch die gestrichelte Kontur 115.7 angedeuteten Magnetfeldes in dem Reluktanzaktuator 115.3 mit einer (nicht dargestellten) Spannungsquelle der Steuereinrichtung 109 verbindbar ist. Hiermit ist es in besonders einfacher Weise möglich, den magnetischen Fluss in diesem Magnetkreis und damit die den Stellkraftbeitrag AFC bzw. in Summe die Stellkraft AFT über eine entsprechende Ansteuerung der Spuleneinheit 115.6 anzupassen.

Der Reluktanzaktuator 115.3 ist in der Variante aus Figur 4 nach Art eines Hubmagneten ausgebildet, bei dem der Beitrag zu der Stellkraft daraus resultiert, dass der Magnetkreis des Reluktanzaktuators 115.3 danach trachtet, den Luftspalt 115.11 des Magnetkreises zwischen der ersten Magnetkreiskomponente 115.4 und der zweiten Magnetkreiskomponente 115.5 zu reduzieren.

Ein solcher Hubmagnet weist typischerweise einen Kraftverlauf auf, bei dem mit Erhöhung des Luftspaltes der Kraftbeitrag AFC der Aktuatoreinheit 115.1 zu der Stellkraft AFT mit zunehmender Relativlageänderung zumindest abschnittsweise proportional abnimmt. Dabei nimmt der Beitrag AFC der Aktuatoreinheit 115.1 zu der Stellkraft AFT mit zunehmender Relativlageänderung zumindest abschnittsweise überproportional ab. Die Aktuatoreinheit 115.1 besitzt somit eine negative Steifigkeit, womit in vorteilhafter Weise die Steifigkeit der Stützfedereinrichtungen 113.1 zumindest teilweise ausgeglichen werden kann. Die negative Steifigkeit der Aktuatoreinheit 115.1 kann somit in entsprechender Abstimmung mit den Stützfedereinrichtungen 113.1 vorteilhaft genutzt werden, um in Summe eine vergleichsweise niedrige Steifigkeit in den Entkopplungsfreiheitsgraden zu erzielen.

Hiermit ist es beispielsweise in vorteilhafter Weise möglich, Stützfedereinrichtungen 113.1 zu verwenden, die eine vergleichsweise hohe Steifigkeit aufweisen und damit in geringerem Maße Kriech- und Setzeffekten unterliegen. Die hohe Steifigkeit der Stützfedereinrichtungen 113.1 kann dann durch die negative Steifigkeit der Aktuatoreinheiten 115.1 kompensiert werden, sodass in Summe zumindest eine dennoch vergleichsweise niedrige Steifigkeit in den Entkopplungsfreiheitsgraden erzielt wird.

Die Aktuatoreinheit 115.2 kann weiterhin grundsätzlich so gestaltet sein, dass sie bereits selbst die erforderliche Entkopplung in bestimmten (für die Abstützung der zweiten Stützstruktur 111.2) erforderlichen Entkopplungsfreiheitsgraden zur Verfügung stellt. Im vorliegenden Beispiel ist die Aktuatoreinheit 115.2 über eine Entkopplungseinrichtung 115.8 mechanisch mit der zweiten Stützstruktur 111.2 verbunden. Die die Entkopplungseinrichtung 115.8 ist dabei dazu ausgebildet, in mehreren von der Stellkraftrichtung der Kraft AFC verschiedenen Entkopplungsfreiheitsgraden eine zumindest teilweise mechanische Entkopplung zwischen der Aktuatoreinheit 115.2 und der Stützstruktur 111.2 zu erzeugen. Im vorliegenden Beispiel handelt es sich bei einem Entkopplungsfreiheitsgrad um einen translatorischen Freiheitsgrad, der quer zu der Stellkraftrichtung verläuft. Zusätzlich besteht eine Entkopplung in einem rotatorischen Freiheitsgrad um eine Achse, die quer zu der Stellkraftrichtung verläuft. In allen diesen Fällen kann auf einfache Weise eine günstige Schwingungsentkopplung erzielt werden.

Die Entkopplungseinrichtung 115.8 ist hierzu als in der Stellkraftrichtung langgestrecktes biegeweiches Entkopplungselement ausgebildet, nämlich als in der Stellkraftrichtung langgestrecktes Blattfederelement oder als in der Stellkraftrichtung langgestrecktes und schlankes, insbesondere biegeweiches, Stabfederelement. In beiden Fällen kann in einfacher Weise die gewünschte Entkopplung erzielt werden.

In der Variante der Figur 4 ist die Stelleinrichtung 115.1 derart ausgebildet, dass die Stellkraft AFT die Stützfedereinrichtungen 113.1 zumindest teilweise entlastet und die Stellkraft AFT zur zumindest teilweisen Kompensation der Relativlageänderung erhöht wird, wie dies bereits beschrieben wurde.

In der nachfolgend beschriebenen Variante der Figur 5 ist die Stelleinrichtung 115.1 jedoch derart ausgebildet, dass die Stellkraft AFT die Stützfedereinrichtungen 113.1 vorspannt und die Stellkraft AFT zur zumindest teilweisen Kompensation der Relativlageänderung verringert wird. Dabei entspricht die Variante der Figur 5 in ihrem grundsätzlichen Aufbau und ihrer Funktionsweise der Variante der Figur 4, sodass hier nur auf die Unterschiede eingegangen werden soll. Gleichartige Komponenten sind mit um den Wert 100 erhöhten Bezugszeichen versehen und es wird, soweit nicht explizit Anderweitiges ausgeführt wird, hinsichtlich der Eigenschaften dieser Komponenten ausdrücklich auf die Ausführungen zur Variante der Figur 4 verwiesen.

Der Unterschied der Variante aus Figur 5 zu der Variante aus Figur 4 besteht darin, dass der Reluktanzaktuator 215.3 (im Vergleich zum Aktuator 115.3) umgedreht wurde, sodass die Stellkraft AFT die Stützfedereinrichtungen 113.1 vorspannt und die Stellkraft AFT zur zumindest teilweisen Kompensation der Relativlageänderung verringert wird. Hierzu wurde im Übrigen lediglich die Entkopplungseinrichtung 115.8 entsprechend angepasst.

Eine weitere Variante wird nachfolgend anhand der Figur 6 beschrieben. Bei dieser Variante bilden eine erste Magnetkerneinheit 315.9 der (mit der ersten Stützstruktur 111.1 verbundenen) ersten Magnetkreiskomponente 315.4 und eine zweite Magnetkerneinheit 315.10 der (mit der zweiten Stützstruktur 111.2 verbundenen) zweiten Magnetkreiskomponente 315.5 unter Ausbildung zweier Luftspalte 315.11 einen Magnetkern eines Magnetkreises des Reluktanzaktuators 315.3.

Auch hier kann die Aktuatoreinheit 315.2 grundsätzlich so gestaltet sein, dass sie bereits selbst die erforderliche Entkopplung in den (für die Abstützung der zweiten Stützstruktur 111.2) erforderlichen Entkopplungsfreiheitsgraden zur Verfügung stellt. Im vorliegenden Beispiel ist die Aktuatoreinheit 315.2 über eine Entkopplungseinrichtung 315.8 mechanisch mit der zweiten Stützstruktur 111.2 verbunden. Die die Entkopplungseinrichtung 315.8 ist dabei wie die Entkopplungseinrichtung 115.8 gestaltet, sodass insoweit auf die obigen Ausführungen zu dieser verwiesen wird.

Der Reluktanzaktuator 315.3 weist dabei dann einen Referenzzustand auf, in dem der Magnetkreis in einen minimierten magnetischen Widerstand (also eine minimierte Reluktanz) aufweist, wie dies durch die gestrichelte Kontur 315.12 angedeutet ist.

Weiterhin weist der Reluktanzaktuator 315.3 einen Stellzustand auf, in dem der Reluktanzaktuator 315.3 einen Beitrag AFC zu der Stellkraft AFT liefert. Dabei wird in der ersten Magnetkerneinheit 315.4 und der zweiten Magnetkerneinheit 315.5 das Magnetfeld 315.7 erzeugt, dessen Magnetfeldlinien in dem Referenzzustand die Luftspalte jeweils in einer Magnetfeldlinienrichtung durchtreten. Weiterhin sind die erste Magnetkerneinheit 315.4 und die zweite Magnetkerneinheit 315.5 in dem Stellzustand gegenüber dem Referenzzustand 315.12 quer zu der Magnetfeldlinienrichtung des Magnetfeldes 315.7 zueinander ausgelenkt.

Die Auslenkung der zweiten Magnetkerneinheit 315.5 zur ersten Magnetkerneinheit 315.4 und ist in der Variante der Figur 7 so gewählt, dass der Beitrag AFC zu der Stellkraft AFT wiederum die Stützfedereinrichtungen 113.1 zumindest teilweise entlastet und die resultierende Stellkraft AFT zur zumindest teilweisen Kompensation der Relativlageänderung erhöht wird, wie dies bereits beschrieben wurde.

Die Variante aus Figur 6 hat dabei den Vorteil, dass der Beitrag AFC der Aktuatoreinheit 315.3 zu der Stellkraft AFT mit zunehmender Relativlageänderung zumindest abschnittsweise im Wesentlichen konstant ist, mithin also die Aktuatoreinheit 315.3 in diesem Bereich der Auslenkung die oben bereits beschriebene Steifigkeit nahe oder gleich Null aufweist. Hiermit kann in vorteilhafter Weise ein Einfluss der Aktuatoreinheit 315.3 auf das Steifigkeitsprofil der Stützfedereinrichtungen 113.1 gering bzw. konstant gehalten werden.

In der nachfolgend beschriebenen Variante der Figur 7 ist die Stelleinrichtung 115.1 schließlich wieder derart ausgebildet, dass die Stellkraft AFT die Stützfedereinrichtungen 113.1 vorspannt und die Stellkraft AFT zur zumindest teilweisen Kompensation der Relativlageänderung verringert wird. Dabei entspricht die Variante der Figur 7 in ihrem grundsätzlichen Aufbau und ihrer Funktionsweise der Variante der Figur 6, sodass hier nur auf die Unterschiede eingegangen werden soll. Gleichartige Komponenten sind mit um den Wert 100 erhöhten Bezugszeichen versehen und es wird, soweit nicht explizit Anderweitiges ausgeführt wird, hinsichtlich der Eigenschaften dieser Komponenten ausdrücklich auf die Ausführungen zur Variante der Figur 6 verwiesen.

Der Unterschied der Variante aus Figur 7 zu der Variante aus Figur 6 besteht lediglich darin, dass die Auslenkung der zweiten Magnetkerneinheit 315.5 zur ersten Magnetkerneinheit 315.4 in der Variante der Figur 7 so gewählt ist, dass der Beitrag AFC zu der Stellkraft AFT die Stützfedereinrichtungen 113.1 vorspannt und die Stell kraft AFT zur zumindest teilweisen Kompensation der Relativlageänderung verringert wird. Hierzu wurde im Übrigen lediglich die Entkopplungseinrichtung 415.8 entsprechend angepasst.

Hierbei kann insbesondere vorgesehen sein, dass die zweite Magnetkerneinheit 315.5 bei der Relativlageänderung den Referenzzustand 315.12 durchläuft. Dabei wird die Kraft AFC in dem Referenzzustand 315.12 gleich Null und dreht sich dann bei weiterer Relativlageänderung um, wobei dann ein Zustand wie in Figur 6 erreicht wird, welcher der Relativlageänderung dann entgegenwirkt.

Weiterhin versteht es sich, dass grundsätzlich innerhalb der Stelleinrichtung grundsätzlich auch die unterschiedlichen Aktuatoreinheiten 115.3 bis 415.3 (der Figuren 4 bis 7) beliebig miteinander kombiniert werden können. Insbesondere kann die jeweilige Aktuatoreinheit 115.3 bis 415.3 dabei speziell auf die zugeordnete Stützfedereinrichtung 113.1 und deren Kriechverhalten bzw. auf deren Lastsituation aufgrund der Massenverteilung der abgestützten zweiten Stützstruktur 111.2 abgestimmt sein.

Mit den vorstehend beschriebenen Gestaltungen lässt sich das erfindungsgemäße Verfahren in der oben beschriebenen Weise ausführen. Dabei wird wie in Figur 8 gezeigt zunächst in einem Schritt 114.1 der Verfahrensablauf gestartet. Dies geschieht beispielsweise mit erstmaliger Inbetriebnahme der Abbildungseinrichtung 101, wobei sich die Abbildungseinrichtung dann in dem ersten Betriebszustand OM1 befindet.

In einem Schritt 114.2 wird dann in der Steuereinrichtung 109 überprüft, ob eines der oben beschriebenen Ereignisse eingetreten ist, welches die Aktivierung des Kriechkompensationsmodus CCM auslöst. Ist dies nicht der Fall, wird diese Überprüfung wiederholt. Ist dies jedoch der Fall, wird in der Steuereinrichtung 109 in einem Schritt 114.3 in der oben beschriebenen Weise die Stellkraft AFT geändert bzw. angepasst, wobei die Steuereinrichtung 109 die Abbildungseinrichtung 101 dann in den zweiten Betriebszustand OM2 versetzt (der dann an die Stelle des ersten Betriebszustands OM1 tritt). In einem Schritt 114.3 wird dann in der Steuereinrichtung 109 überprüft, ob der Verfahrensablauf beendet werden soll. Ist dies nicht der Fall, wird zum Schritt 114.2 zurück gesprungen. Andernfalls endet der Verfahrensablauf in einem Schritt 114.4. Im Übrigen wird hinsichtlich weiterer Details des Verfahrens zur Vermeidung von Wiederholungen auf die obigen Ausführungen verwiesen.

Die vorliegende Erfindung wurde vorstehend ausschließlich anhand von Beispielen beschrieben, bei denen die Lage jedes der optischen Elemente der Elementgruppe 107.1 bezüglich der zentralen Referenz 112 aktiv eingestellt wurde. Es versteht sich jedoch, dass bei anderen Varianten auch nur ein Teil (gegebenenfalls sogar nur eines) der optischen Elemente der Elementgruppe 107.1 unmittelbar bezüglich der zentralen Referenz 112 aktiv eingestellt werden kann, während die übrigen optischen Elemente der Elementgruppe 107.1 relativ zu einem dieser bezüglich der zentralen Referenz 112 aktiv eingestellten optischen Elemente aktiv eingestellt werden. Insbesondere kann nur eines der optischen Elemente der Elementgruppe 107.1 als Referenzelement dienen und unmittelbar bezüglich der zentralen Referenz 112 aktiv eingestellt werden, während alle übrigen optischen Elemente der Elementgruppe 107.1 relativ zu diesem Referenzelement (und damit also nur mittelbar bezüglich der zentralen Referenz 112) aktiv eingestellt werden.

Die vorliegende Erfindung wurde vorstehend ausschließlich anhand von Beispielen aus dem Bereich der Mikrolithographie beschrieben. Es versteht sich jedoch, dass die Erfindung auch im Zusammenhang mit beliebigen anderen optischen Anwendungen, insbesondere Abbildungsverfahren bei anderen Wellenlängen, zum Einsatz kommen kann, bei denen sich ähnliche Probleme hinsichtlich der Abstützung schwerer optischer Einheiten stellen.

Weiterhin kann die Erfindung im Zusammenhang mit der Inspektion von Objekten, wie beispielsweise der so genannten Maskeninspektion zu Einsatz kommen, bei welcher die für die Mikrolithographie verwendeten Masken auf ihre Integrität etc. untersucht werden. An Stelle des Substrats 105.1 tritt dann in Figur 1 beispielsweise eine Sensoreinheit, welche die Abbildung des Projektionsmusters der Maske 104.1 (zur weiteren Verarbeitung) erfasst. Diese Maskeninspektion kann dann sowohl im Wesentlichen bei derselben Wellenlänge erfolgen, die im späteren Mikrolithographieprozess verwendet wird. Ebenso können aber auch beliebige hiervon abweichende Wellenlängen für die Inspektion verwendet werden.

Die vorliegende Erfindung wurde vorstehend schließlich anhand konkreter Ausführungsbeispiele beschrieben, welches konkrete Kombinationen der in den nachfolgenden Patentansprüchen definierten Merkmale zeigt. Es sei an dieser Stelle ausdrücklich darauf hingewiesen, dass der Gegenstand der vorliegenden Erfindung nicht auf diese Merkmalskombinationen beschränkt ist, sondern auch sämtliche übrigen Merkmalskombinationen, wie sie sich aus den nachfolgenden Patentansprüchen ergeben, zum Gegenstand der vorliegenden Erfindung gehören.

## Patentansprüche

1. Anordnung einer optischen Abbildungseinrichtung für die Mikrolithographie, insbesondere für die Verwendung von Licht im extremen UV-Bereich (EUV), mit
- einer ersten Stützstruktur (111.1) und
- einer zweiten Stützstruktur (111.2),
wobei
- die erste Stützstruktur (111.1) dazu ausgebildet ist, wenigstens ein optisches Element (107.2) der Abbildungseinrichtung abzustützen,
- die erste Stützstruktur (111.1) die zweite Stützstruktur (111.2) über eine Mehrzahl von Stützfedereinrichtungen (113.1) einer Schwingungsentkopplungseinrichtung (113) abstützt,
- die Stützfedereinrichtungen (113.1) kinematisch parallel zueinander zwischen der ersten Stützstruktur (111.1) und der zweiten Stützstruktur (111.2) wirken,
- jede der Stützfedereinrichtungen (113.1) eine Stützkraftrichtung definiert, in der sie eine Stützkraft zwischen der ersten Stützstruktur (111.1) und der zweiten Stützstruktur (111.2) ausübt, sowie eine Stützlänge entlang der Stützkraftrichtung definiert und
- die zweite Stützstruktur (111.2) eine Messeinrichtung (109.1) abstützt, die zum Messen der Position und/oder Orientierung des wenigstens einen optischen Elements (107.2) bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Kriechkompensationseinrichtung (115) zur Kompensation einer Änderung einer statischen Relativlage zwischen der ersten Stützstruktur (111.1) und der zweiten Stützstruktur (111.2) in wenigstens einem Korrekturfreiheitsgrad vorgesehen ist,
wobei
- die Relativlageänderung insbesondere durch eine Längenänderung wenigstens einer der Stützfedereinrichtungen (113.1) entlang ihrer Stützkraftrichtung bedingt ist, die sich aus einem Kriechprozess der Stützfedereinrichtung ergibt,
- die Kriechkompensationseinrichtung (115) eine kinematisch parallel zu den Stützfedereinrichtungen (113.1) zwischen der ersten Stützstruktur (111.1) und der zweiten Stützstruktur (111.2) wirkende, ansteuerbare aktive Stelleinrichtung (115.1) mit wenigstens einer aktiven Aktuatoreinheit (115.2) umfasst und
- die Stelleinrichtung (115.1) dazu ausgebildet ist, eine Stellkraft auf die zweite Stützstruktur (111.2) auszuüben und zur zumindest teilweisen Kompensation der Relativlageänderung die Stellkraft zu verändern.

2. Anordnung nach Anspruch 1, wobei
- die Stelleinrichtung (115.1) wenigstens eine aktive Aktuatoreinheit (115.2) mit einem Reluktanzaktuator (115.3; 215.3; 315.3; 415.3) umfasst
und/oder
- die Stelleinrichtung (115.1) wenigstens eine aktive Aktuatoreinheit (115.2) mit einem Lorentz-Aktuator umfasst.

3. Anordnung nach Anspruch 1 oder 2, wobei
- die Stelleinrichtung (115.1) derart ausgebildet ist, dass die Stellkraft die Stützfedereinrichtungen (113.1) zumindest teilweise entlastet und die Stell kraft zur zumindest teilweisen Kompensation der Relativlageänderung erhöht wird,
oder
- die Stelleinrichtung (115.1) derart ausgebildet ist, dass die Stellkraft die Stützfedereinrichtungen (113.1) vorspannt und die Stellkraft zur zumindest teilweisen Kompensation der Relativlageänderung verringert wird.

4. Anordnung nach Anspruch 3, wobei
- die Stelleinrichtung (115.1) zur Entlastung der Stützfedereinrichtungen (113.1) derart ausgebildet ist, dass die Stellkraft wenigstens einen Anteil der Gesamtgewichtskraft der zweiten Stützstruktur (111.2) und der von der zweiten Stützstruktur (111.2) getragenen Komponenten ausgleicht,
wobei insbesondere
- der Anteil wenigstens 0,1% bis 30%, vorzugsweise wenigstens 0,5% bis 6%, weiter vorzugsweise wenigstens 1% bis 3%, der Gesamtgewichtskraft beträgt.

5. Anordnung nach einem der Ansprüche 1 bis 4, wobei
- wenigstens einer der Stützfedereinrichtungen (113.1) wenigstens eine aktive Aktuatoreinheit (115.2) funktionell, insbesondere räumlich, zugeordnet ist,
wobei insbesondere
- mehreren der Stützfedereinrichtungen (113.1), insbesondere jeder der Stützfedereinrichtungen (113.1), jeweils wenigstens eine aktive Aktuatoreinheit (115.2), insbesondere genau eine aktive Aktuatoreinheit (115.2), funktionell zugeordnet ist.

6. Anordnung nach einem der Ansprüche 1 bis 5, wobei
- wenigstens eine aktive Aktuatoreinheit (115.2) wenigstens einen Reluktanzaktuator (115.3; 215.3; 315.3; 415.3) mit einer ersten Magnetkreiskomponente (115.4; 315.4) und einer zweiten Magnetkreiskomponente (115.5; 315.5) umfasst, die einander zum berührungslosen Zusammenwirken zugeordnet sind,
wobei insbesondere
- die erste Magnetkreiskomponente (115.4; 315.4) mechanisch mit der ersten Stützstruktur (111.1) verbunden ist und die zweite Magnetkreiskomponente (115.5; 315.5) mechanisch mit der zweiten Stützstruktur (111.2) verbunden ist
und/oder
- eine der Magnetkreiskomponenten, insbesondere die erste Magnetkreiskomponente (115.4; 315.4), eine Spuleneinheit (115.6; 315.6) umfasst, die zur Erzeugung eines Magnetfeldes in dem Reluktanzaktuator (115.3; 215.3; 315.3; 415.3) mit einer Spannungsquelle verbindbar ist.
und/oder
- die Aktuatoreinheit (115.2) nach Art eines Hubmagneten ausgebildet ist.

7. Anordnung nach Anspruch 6, wobei
- eine erste Magnetkerneinheit der ersten Magnetkreiskomponente (315.4) und eine zweite Magnetkerneinheit der zweiten Magnetkreiskomponente (315.5) unter Ausbildung zweier Luftspalte (315.11) einen Magnetkern eines Magnetkreises des Reluktanzaktuators (315.3; 415.3) bilden,
- der Reluktanzaktuator (315.3; 415.3) einen Referenzzustand aufweist, in dem der Magnetkreis in einen minimierten magnetischen Widerstand aufweist,
- der Reluktanzaktuator (315.3; 415.3) einen Stellzustand aufweist, in dem der Reluktanzaktuator (315.3; 415.3) zumindest einen Beitrag zu der Stellkraft liefert,
- der Reluktanzaktuator (315.3; 415.3) derart ausgebildet ist, dass in der ersten Magnetkerneinheit und der zweiten Magnetkerneinheit ein Magnetfeld erzeugt wird, dessen Magnetfeldlinien in dem Referenzzustand die Luftspalte (315.11) jeweils in einer Magnetfeldlinienrichtung durchtreten, und
- der Reluktanzaktuator (315.3; 415.3) derart ausgebildet und angeordnet ist, dass die erste Magnetkerneinheit und die zweite Magnetkerneinheit in dem Stellzustand gegenüber dem Referenzzustand quer zu der Magnetfeldlinienrichtung zueinander ausgelenkt sind.

8. Anordnung nach einem der Ansprüche 1 bis 7, wobei
- die wenigstens eine aktive Aktuatoreinheit (115.2) derart ausgebildet ist, dass sie eine negative Steifigkeit aufweist,,
und/oder
- die wenigstens eine aktive Aktuatoreinheit (115.2) derart ausgebildet ist, dass der Beitrag der Aktuatoreinheit (115.2) zu der Stellkraft mit zunehmender Relativlageänderung zumindest abschnittsweise proportional abnimmt,
und/oder
- die wenigstens eine aktive Aktuatoreinheit (115.2) derart ausgebildet ist, dass der Beitrag der Aktuatoreinheit (115.2) zu der Stellkraft mit zunehmender Relativlageänderung zumindest abschnittsweise überproportional abnimmt,
und/oder
- die wenigstens eine aktive Aktuatoreinheit (115.2) derart ausgebildet ist, dass der Beitrag der Aktuatoreinheit (115.2) zu der Stellkraft mit zunehmender Relativlageänderung zumindest abschnittsweise im Wesentlichen konstant ist.

9. Anordnung nach einem der Ansprüche 1 bis 8, wobei
- die wenigstens eine aktive Aktuatoreinheit (115.2) im Betrieb in einer Stellkraftrichtung ihren Beitrag zu der Stellkraft auf die zweite Stützstruktur (111.2) ausübt,
- die wenigstens eine aktive Aktuatoreinheit (115.2) mit einer der Stützstrukturen (111.1, 111.2), insbesondere mit der zweiten Stützstruktur (111.2), über eine Entkopplungseinrichtung (115.8; 215.8; 315.8; 415.8) mechanisch verbunden ist und
- die Entkopplungseinrichtung (115.8; 215.8; 315.8; 415.8) dazu ausgebildet ist, in wenigstens einem von der Stellkraftrichtung verschiedenen Entkopplungsfreiheitsgrad eine zumindest teilweise mechanische Entkopplung zwischen der Aktuatoreinheit (115.2) und der Stützstruktur (111.2) zu erzeugen,
wobei insbesondere
- der wenigstens eine Entkopplungsfreiheitsgrad ein translatorischer Freiheitsgrad ist, der quer zu der Stellkraftrichtung verläuft,
und/oder
- der wenigstens eine Entkopplungsfreiheitsgrad ein rotatorischer Freiheitsgrad um eine Achse ist, die quer zu der Stellkraftrichtung verläuft.

10. Anordnung nach einem der Ansprüche 1 bis 9, wobei
- wenigstens eine aktive Aktuatoreinheit (115.2) im Betrieb in einer Stellkraftrichtung ihren Beitrag zu der Stellkraft auf eine der Stützstrukturen (111.1, 111.2) ausübt und
- die wenigstens eine aktive Aktuatoreinheit (115.2) über eine Entkopplungseinrichtung (115.8; 215.8; 315.8; 415.8), die sich in der Stellkraftrichtung erstreckt, mechanisch mit der Stützstruktur (111.2) verbunden ist,
wobei insbesondere
- die Entkopplungseinrichtung (115.8; 215.8; 315.8; 415.8) ein in der Stellkraftrichtung langgestrecktes biegeweiches Entkopplungselement umfasst
und/oder
- die Entkopplungseinrichtung (115.8; 215.8; 315.8; 415.8) ein in der Stellkraftrichtung langgestrecktes Blattfederelement umfasst
und/oder
- die Entkopplungseinrichtung (115.8; 215.8; 315.8; 415.8) ein in der Stellkraftrichtung langgestrecktes und schlankes, insbesondere biegeweiches, Stabfederelement umfasst.

11. Anordnung nach einem der Ansprüche 1 bis 10, wobei
- eine Steuereinrichtung (109) vorgesehen ist und
- die Steuereinrichtung (109) dazu ausgebildet ist, in Abhängigkeit von der Längenänderung der wenigstens einen Stützfedereinrichtung (113.1) entlang ihrer Stützkraftrichtung die Stelleinrichtung (115.1) zur Änderung der Stellkraft anzusteuern,
wobei insbesondere
- die Steuereinrichtung (109) zur Ermittlung der Längenänderung der wenigstens einen Stützfedereinrichtung (113.1) entlang ihrer Stützkraftrichtung ein das Kriechverhalten der Stützfedereinrichtung (113.1) beschreibendes Kriechmodell der Stützfedereinrichtung (113.1) verwendet.

12. Anordnung nach einem der Ansprüche 1 bis 11, wobei
- eine Erfassungseinrichtung (109.4) und eine Steuereinrichtung (109) vorgesehen ist,
- die Erfassungseinrichtung (109.4) dazu ausgebildet ist, wenigstens einen für die Relativlage zwischen der ersten Stützstruktur (111.1) und der zweiten Stützstruktur (111.2) in wenigstens einem Korrekturfreiheitsgrad repräsentativen Relativlageerfassungswert zu erfassen und an die Steuereinrichtung (109) auszugeben, und
- die Steuereinrichtung (109) dazu ausgebildet ist, in Abhängigkeit von dem Relativlageerfassungswert, insbesondere in Abhängigkeit von einer zeitlichen Änderung des Relativlageerfassungswerts, die Stelleinrichtung (115.1) zur Änderung der Stellkraft anzusteuern.

13. Anordnung nach Anspruch 12, wobei
- die Steuereinrichtung (109) dazu ausgebildet ist, die Stelleinrichtung (115.1) erst anzusteuern, wenn eine Abweichung des Relativlageerfassungswerts von einem vorgebbaren Relativlagesollwert in dem wenigstens einen Korrekturfreiheitsgrad einen vorgebbaren Grenzwert überschreitet,
wobei insbesondere
- die Steuereinrichtung (109) eine Regelbandbreite von 0,5 µ Hz bis 500 Hz, vorzugsweise 0,01 Hz bis 100 Hz, weiter vorzugsweise 0,1 Hz bis 10 Hz, aufweist
und/oder
- der Korrekturfreiheitsgrad ein Rotationsfreiheitsgrad ist, insbesondere ein Rotationsfreiheitsgrad um eine quer zu der Gravitationsrichtung verlaufende Kippachse ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µrad bis 1000 µrad, vorzugsweise 1 µrad bis 200 µrad, weiter vorzugsweise 10 µrad bis 100 µrad, repräsentativ ist
und/oder
- der Korrekturfreiheitsgrad ein Translationsfreiheitsgrad ist, insbesondere ein Translationsfreiheitsgrad entlang der Gravitationsrichtung ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µm bis 1000 µm, vorzugsweise 1 µm bis 200 µm, weiter vorzugsweise 10 µm bis 100 µm, repräsentativ ist.

14. Anordnung nach Anspruch 12 oder 13, wobei
- der wenigstens eine Korrekturfreiheitsgrad ein Rotationsfreiheitsgrad um eine quer zu der Gravitationsrichtung verlaufende Kippachse ist
und/oder
- der wenigstens eine Korrekturfreiheitsgrad ein Translationsfreiheitsgrad entlang der Gravitationsrichtung ist.

15. Optische Abbildungseinrichtung, insbesondere für die Mikrolithographie, mit
- einer Beleuchtungseinrichtung (102) mit einer ersten optischen Elementgruppe (106),
- einer Objekteinrichtung (104) zur Aufnahme eines Objekts (104.1),
- einer Projektionseinrichtung (103) mit einer zweiten optischen Elementgruppe (107) und
- einer Bildeinrichtung (105), wobei
- die Beleuchtungseinrichtung (102) zur Beleuchtung des Objekts (104.1) ausgebildet ist und
- die Projektionseinrichtung (103) zur Projektion einer Abbildung des Objekts (103.1) auf die Bildeinrichtung (105) ausgebildet ist,
**dadurch gekennzeichnet, dass**
- die Beleuchtungseinrichtung (102) und/oder die Projektionseinrichtung (103) wenigstens eine Anordnung (108) nach einem der Ansprüche 1 bis 14 umfasst.

16. Verfahren für eine optische Abbildungseinrichtung für die Mikrolithographie, insbesondere für die Verwendung von Licht im extremen UV-Bereich (EUV), bei dem
- eine erste Stützstruktur (111.1) eine zweite Stützstruktur (111.2) über eine Mehrzahl von Stützfedereinrichtungen (113.1) einer Schwingungsentkopplungseinrichtung abstützt und dazu ausgebildet ist, wenigstens ein optisches Element (107.2) der Abbildungseinrichtung abzustützen,
- die Stützfedereinrichtungen (113.1) kinematisch parallel zueinander zwischen der ersten Stützstruktur (111.1) und der zweiten Stützstruktur (111.2) wirken,
- jede der Stützfedereinrichtungen (113.1) eine Stützkraftrichtung definiert, in der sie eine Stützkraft zwischen der ersten Stützstruktur (111.1) und der zweiten Stützstruktur (111.2) ausübt, sowie eine Stützlänge entlang der Stützkraftrichtung definiert und
- die zweite Stützstruktur (111.2) eine Messeinrichtung (109.1) abstützt, die zum Messen der Position und/oder Orientierung des wenigstens einen optischen Elements (107.2) bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Änderung einer statischen Relativlage zwischen der ersten Stützstruktur (111.1) und der zweiten Stützstruktur (111.2) in wenigstens einem Freiheitsgrad in einem Kompensationsschritt zumindest teilweise kompensiert wird,
wobei
- die Relativlageänderung durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt, und
- kinematisch parallel zu den Stützfedereinrichtungen (113.1) zwischen der ersten Stützstruktur (111.1) und der zweiten Stützstruktur (111.2) eine Stellkraft auf die zweite Stützstruktur (111.2) ausgeübt wird und zur zumindest teilweisen Kompensation der Relativlageänderung die Stellkraft verändert wird.

17. Verfahren nach Anspruch 16, wobei
- Zur Erzeugung der Stellkraft wenigstens eine aktive Aktuatoreinheit (115.2) mit einem Reluktanzaktuator (115.3; 215.3; 315.3; 415.3) verwendet wird
und/oder
- Zur Erzeugung der Stellkraft wenigstens eine aktive Aktuatoreinheit (115.2) mit einem Lorentz-Aktuator verwendet wird.

18. Verfahren nach Anspruch 16 oder 17, wobei
- die Stellkraft die Stützfedereinrichtungen (113.1) zumindest teilweise entlastet und die Stellkraft zur zumindest teilweisen Kompensation der Relativlageänderung erhöht wird,
oder
- die Stellkraft die Stützfedereinrichtungen (113.1) vorspannt und die Stellkraft zur zumindest teilweisen Kompensation der Relativlageänderung verringert wird.

19. Verfahren nach einem der Ansprüche 16 bis 18, wobei
- zur Erzeugung der Stellkraft wenigstens ein Reluktanzaktuator (115.3; 215.3; 315.3; 415.3) mit berührungslos zusammenwirkenden ersten und zweiten Magnetkreiskomponenten verwendet wird,
wobei insbesondere
- eine erste Magnetkerneinheit der ersten Magnetkreiskomponente (115.4; 315.4) und eine zweite Magnetkerneinheit der zweiten Magnetkreiskomponente (115.5; 315.5) unter Ausbildung zweier Luftspalte einen Magnetkern eines Magnetkreises des Reluktanzaktuators (115.3; 215.3; 315.3; 415.3) bilden,
- der Reluktanzaktuator (115.3; 215.3; 315.3; 415.3) einen Referenzzustand aufweist, in dem der Magnetkreis in einen minimierten magnetischen Widerstand aufweist,
- der Reluktanzaktuator (115.3; 215.3; 315.3; 415.3) einen Stellzustand aufweist, in dem der Reluktanzaktuator (115.3; 215.3; 315.3; 415.3) zumindest einen Beitrag zu der Stellkraft liefert,
- der Reluktanzaktuator (115.3; 215.3; 315.3; 415.3) in der ersten Magnetkerneinheit und der zweiten Magnetkerneinheit ein Magnetfeld erzeugt, dessen Magnetfeldlinien in dem Referenzzustand die Luftspalte jeweils in einer Magnetfeldlinienrichtung durchtreten, und
- die erste Magnetkerneinheit und die zweite Magnetkerneinheit in dem Stellzustand gegenüber dem Referenzzustand quer zu der Magnetfeldlinienrichtung zueinander ausgelenkt werden.

20. Verfahren nach einem der Ansprüche 16 bis 19, wobei
- über wenigstens eine aktive Aktuatoreinheit (115.2) der Stelleinrichtung (115.1) im Betrieb die Stellkraft auf eine der Stützstrukturen (111.1, 111.2) ausgeübt wird,
- die wenigstens eine aktive Aktuatoreinheit (115.2) über eine Entkopplungseinrichtung (115.8; 215.8; 315.8; 415.8) mechanisch mit der Stützstruktur (111.2) verbunden ist, insbesondere mit der zweiten Stützstruktur (111.2) verbunden ist, und
- in wenigstens einem von der Stellkraftrichtung verschiedenen Entkopplungsfreiheitsgrad eine zumindest teilweise mechanische Entkopplung zwischen der Aktuatoreinheit (115.2) und der Stützstruktur (111.2) erfolgt, wobei insbesondere
- der wenigstens eine Entkopplungsfreiheitsgrad ein translatorischer Freiheitsgrad ist, der quer zu der Stützkraftrichtung verläuft,
und/oder
- der wenigstens eine Entkopplungsfreiheitsgrad ein rotatorischer Freiheitsgrad um eine Achse ist, die quer zu der Stützkraftrichtung verläuft.

21. Verfahren nach einem der Ansprüche 16 bis 20, wobei
- in Abhängigkeit von der Längenänderung der wenigstens einen Stützfedereinrichtung (113.1) entlang ihrer Stützkraftrichtung die Stellkraft geändert wird,
wobei insbesondere
- zur Ermittlung der Längenänderung der wenigstens einen Stützfedereinrichtung (113.1) entlang ihrer Stützkraftrichtung ein das Kriechverhalten der Stützfedereinrichtung (113.1) beschreibendes Kriechmodell der Stützfedereinrichtung (113.1) verwendet wird.

22. Verfahren nach einem der Ansprüche 16 bis 21, wobei
- wenigstens ein für die Relativlage zwischen der ersten Stützstruktur (111.1) und der zweiten Stützstruktur (111.2) in wenigstens einem Korrekturfreiheitsgrad repräsentativer Relativlageerfassungswert erfassen wird und
- in Abhängigkeit von dem Relativlageerfassungswert, insbesondere in Abhängigkeit von einer zeitlichen Änderung des Relativlageerfassungswerts, die Stellkraft geändert wird.

23. Verfahren nach Anspruch 22, wobei
- die Magnetstützkraft erst geändert wird, wenn eine Abweichung des Relativlageerfassungswerts von einem vorgebbaren Relativlagesollwert in dem wenigstens einen Korrekturfreiheitsgrad einen vorgebbaren Grenzwert überschreitet,
wobei insbesondere
- eine Regelbandbreite von 0,5 µHz bis 500 Hz, vorzugsweise 0,01 Hz bis 100 Hz, weiter vorzugsweise 0,1 Hz bis 10 Hz, verwendet wird
und/oder
- der Korrekturfreiheitsgrad ein Rotationsfreiheitsgrad ist, insbesondere ein Rotationsfreiheitsgrad um eine quer zu der Gravitationsrichtung verlaufende Kippachse ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µrad bis 1000 µrad, vorzugsweise 1 µrad bis 200 µrad, weiter vorzugsweise 10 µrad bis 100 µrad, repräsentativ ist
und/oder
- der Korrekturfreiheitsgrad ein Translationsfreiheitsgrad ist, insbesondere ein Translationsfreiheitsgrad entlang der Gravitationsrichtung ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µm bis 1000 µm, vorzugsweise 1 µm bis 200 µm, weiter vorzugsweise 10 µm bis 100 µm, repräsentativ ist.

24. Verfahren nach Anspruch 22 oder 23, wobei
- der wenigstens eine Korrekturfreiheitsgrad ein Rotationsfreiheitsgrad um eine quer zu der Gravitationsrichtung verlaufende Kippachse ist
und/oder
- der wenigstens eine Korrekturfreiheitsgrad ein Translationsfreiheitsgrad entlang der Gravitationsrichtung ist.
